(19) **Europäisches Patentamt European Patent Office Office européen des brevets**

(11) **EP 4 404 113 B1**

(12) **EUROPEAN PATENT SPECIFICATION**

(45) Date of publication and mention of the grant of the patent:
**01.07.2026 Bulletin 2026/27**

(21) Application number: **22869937.7**

(22) Date of filing: **12.09.2022**

(51) International Patent Classification (IPC):
**G06N 20/10** *(2019.01)* **G06Q 10/04** *(2023.01)*
**H01M 10/48** *(2006.01)* **G01R 31/392** *(2019.01)*
**G01R 31/367** *(2019.01)*

(52) Cooperative Patent Classification (CPC):
**G06Q 10/04; G01R 31/367; G01R 31/392;**
**G06N 20/10; H01M 10/48**

(86) International application number:
**PCT/JP2022/034046**

(87) International publication number:
**WO 2023/042790 (23.03.2023 Gazette 2023/12)**

(54) **PREDICTION DATA DISPLAY DEVICE, PREDICTION DATA DISPLAY METHOD, AND PREDICTION DATA DISPLAY PROGRAM**

ANZEIGEVORRICHTUNG FÜR VORHERSAGEDATEN, ANZEIGEVERFAHREN FÜR VORHERSAGEDATEN UND ANZEIGEPROGRAMM FÜR VORHERSAGEDATEN

DISPOSITIF D'AFFICHAGE DE DONNÉES DE PRÉDICTION, PROCÉDÉ D'AFFICHAGE DE DONNÉES DE PRÉDICTION ET PROGRAMME D'AFFICHAGE DE DONNÉES DE PRÉDICTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.09.2021 JP 2021150217**

(43) Date of publication of application:
**24.07.2024 Bulletin 2024/30**

(73) Proprietor: **Resonac Corporation**
**Tokyo 105-7325 (JP)**

(72) Inventors:
• **KURAUCHI, Yuji**
**Tokyo 105-8518 (JP)**
• **TAKEMOTO, Shimpei**
**Tokyo 105-8518 (JP)**
• **OKUNO, Yoshishige**
**Tokyo 105-8518 (JP)**

(74) Representative: **Strehl & Partner mbB**
**Maximilianstrasse 54**
**80538 München (DE)**

(56) References cited:
EP-A1- 3 770 620          EP-A1- 3 862 764
WO-A1-2017/065821          WO-A1-2019/097357
CN-A- 111 413 619          JP-A- 2019 168 453
JP-A- 2021 124 419

• TAYLOR SEAN J ET AL: "Forecasting at scale", 27 September 2017 (2017-09-27), XP055938148, Retrieved from the Internet <URL:https://peerj.com/preprints/3190v2.html> [retrieved on 20250718], DOI: 10.7287/peerj.preprints.3190v2
• LI OSCAR ET AL: "Deep learning for case-based reasoning through prototypes: A neural network that explains its predictions", ARXIV (CORNELL UNIVERSITY), 21 November 2017 (2017-11-21), XP093181818, Retrieved from the Internet <URL:https://arxiv.org/pdf/1710.04806> [retrieved on 20250718], DOI: 10.48550/arXiv.1710.04806

EP 4 404 113 B1

- **WANG GUANYU ET AL: "Machine-Learning Approach for Predicting the Discharging Capacities of Doped Lithium Nickel-Cobalt-Manganese Cathode Materials in Li-Ion Batteries", vol. 7, no. 9, 20 August 2021 (2021-08-20), pages 1551 - 1560, XP093298244, ISSN: 2374-7943, Retrieved from the Internet <URL:https://pubs.acs.org/doi/pdf/10.1021/acscentsci.1c00611?ref=article_openPDF> [retrieved on 20250722], DOI: 10.1021/acscentsci.1c00611**

## Description

### TECHNICAL FIELD

The present disclosure relates to a prediction data display device, a prediction data display method, and a prediction data display program.

### BACKGROUND ART

A prediction technique for predicting a degree of deterioration of a consumable such as a battery using a machine learning model has been known. According to the prediction technique, for example, characteristic data after deterioration of a consumable to be predicted can be predicted from characteristic data before the deterioration of the consumable to be predicted by acquiring characteristic data indicating a degree of deterioration of the consumable for a certain period of time and training a relationship between characteristic data before deterioration and characteristic data after deterioration.

EP 3 770 620 A1 and Taylor Sean J ET AL: "Forecasting at scale", PeerJPreprints, 27 July 2017. disclose machine learning based prediction systems comprising a prediction part and a display part.

### RELATED ART DOCUMENT

### PATENT DOCUMENT

Patent Document 1: Japanese Translation of PCT International Application No. 2010-539473
Patent Document 2: Japanese Unexamined Patent Application Publication No. 2013-217897
Patent Document 3: Japanese Unexamined Patent Application Publication No. 2019-113524

### DISCLOSURE OF THE INVENTION

### PROBLEM TO BE SOLVED BY THE INVENTION

In a case of a prediction technique that performs prediction using a machine learning model, it is however difficult for a user to determine whether or not prediction data is correct.

The present disclosure enables to more easily determine whether or not prediction data is correct when a degree of deterioration of a consumable is predicted using a machine learning model.

### MEANS FOR SOLVING THE PROBLEM

The invention is set forth in the independent claims and further embodiments are defined in the dependent claims.

### EFFECT OF THE INVENTION

The present disclosure enables to more easily determine whether or not prediction data of a degree of deterioration of a consumable is correct when the degree is predicted using a machine learning model.

### BRIEF DESCRIPTION OF THE DRAWINGS

[FIG. 1] FIG. 1 is a diagram illustrating a system configuration example of a prediction data display system and a functional configuration example of a training device in a training phase.
[FIG. 2] FIG. 2 is a diagram illustrating a specific example of processing of a training data generating device.
[FIG. 3] FIG. 3 is a diagram illustrating a system configuration example of the prediction data display system and a functional configuration example of a prediction data display device in a prediction phase.
[FIG. 4] FIG. 4 is a diagram illustrating a specific example of processing of a predictive data generating device.
[FIG. 5] FIG. 5 is a diagram illustrating a hardware configuration example of the training device and the prediction data display device.
[FIG. 6] FIG. 6 is a diagram illustrating a specific example of processing of a first scale converter of the prediction data display device.

[FIG. 7] FIG. 7 is a diagram illustrating a specific example of processing of a trained Gaussian process regression model of the prediction data display device.

[FIG. 8] FIG. 8 is a diagram illustrating a specific example of processing of a second scale converter of the prediction data display device.

[FIG. 9] FIG. 9 is a diagram illustrating examples of graphs of prediction data and a 95% confidence interval.

[FIG. 10] FIG. 10 is a first diagram illustrating a specific example of processing of a display screen generating part of the prediction data display device.

[FIG. 11] FIG. 11 is a second diagram illustrating a specific example of the processing of the display screen generating part of the prediction data display device.

[FIG. 12] FIG. 12 is a flowchart illustrating a flow of a training process.

[FIG. 13] FIG. 13 is a first flowchart illustrating a flow of a prediction data display process.

[FIG. 14] FIG. 14 is a third diagram illustrating a specific example of the processing of the display screen generating part of the prediction data display device.

[FIG. 15] FIG. 15 is a second flowchart illustrating a flow of the prediction data display process.

[FIG. 16] FIG. 16 is a fourth diagram illustrating a specific example of the processing of the display screen generating part of the prediction data display device.

MODE OF CARRYING OUT THE INVENTION

Hereinafter, embodiments will be described with reference to the accompanying drawings. In this specification and the drawings, components having substantially the same functional configuration are denoted by the same reference numerals, and redundant description thereof will be omitted.

[First Embodiment]

<System Configuration of Prediction Data Display System and Functional Configuration of Training Device in Training Phase>

First, in a training phase, a system configuration of a prediction data display system and a functional configuration of a training device constituting the prediction data display system will be described.

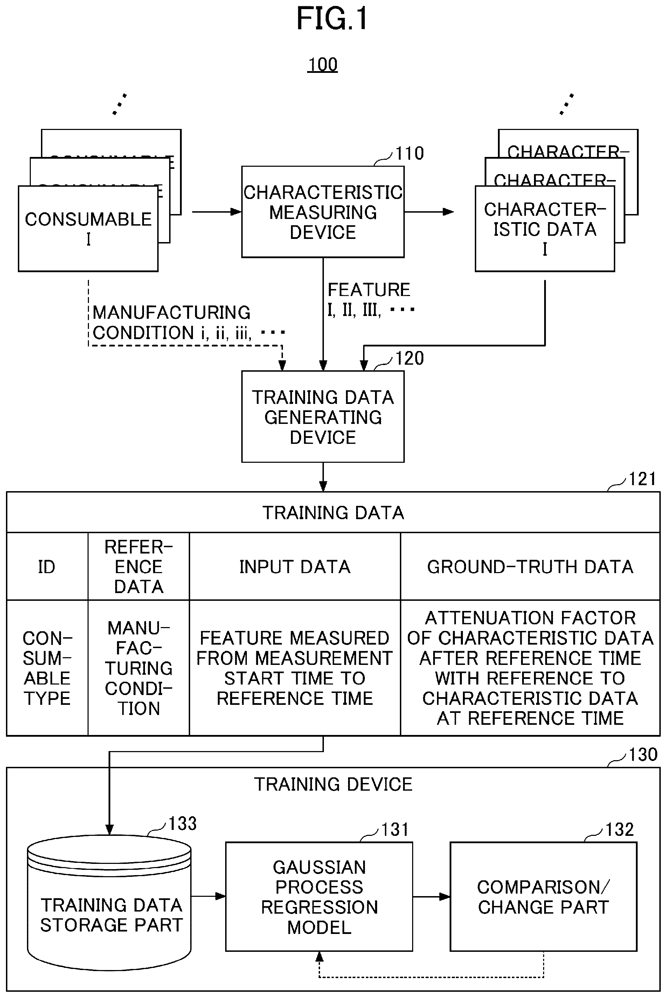

FIG. 1 is a diagram illustrating a system configuration example of the prediction data display system and a functional configuration example of the training device in the training phase. As illustrated in FIG. 1, a prediction data display system 100 in the training phase includes a characteristic measuring device 110, a training data generating device 120, and a training device 130.

The characteristic measuring device 110 measures a feature as information on characteristic data indicating a degree of deterioration of a consumable to generate the characteristic data based on the measured feature. The consumable refers to a battery. The characteristic data indicating a degree of deterioration refers to a discharge capacity retention rate in each cycle in a test in which charging and discharging of the battery are repeated. A feature, which is the information on the characteristic data, refers to current data, voltage data, or the like measured in each cycle.

The battery referred to herein includes various batteries, and a lithium ion secondary battery is given as an example. The lithium ion secondary battery includes those manufactured under different manufacturing conditions from the viewpoints of material development and cell design. More specifically, the lithium ion secondary battery includes batteries manufactured by variously comparing and changing constituent members such as a positive electrode material, a negative electrode material, and an electrolytic material constituting the lithium ion secondary battery, and batteries manufactured by variously comparing and changing conditions such as activation and aging after completion of battery assembly.

Note that, the characteristic measuring device 110 acquires characteristic data for various types of consumables (a first consumable, a battery). The example in FIG. 1 illustrates a state in which characteristic data I, II, III, ... are generated by measuring features I, II, III, ... for consumables I, II, III, ... of different types, respectively.

The generated characteristic data I, II, III, ... are input to the training data generating device 120 together with the features I, II, III, ... and manufacturing conditions i, ii, iii, ... of the respective consumables.

The training data generating device 120 generates training data 121 used for a training process by the training device 130. As illustrated in FIG. 1, the training data 121 includes "ID", "Reference data", "Input data", and "Ground-truth data" as information items. The following contents are input as the respective information items:

•    "ID" :                        consumable types;

(continued)

- "Reference data": consumable manufacturing conditions;
- "Input data": features measured from a measurement start time to a reference time; and
- "Ground-truth data": attenuation factors of characteristic data after the reference time with reference to the characteristic data at the reference time.

The reference time refers to, in a period from the start to the end of the characteristic measuring device 110 measuring a feature as information on characteristic data indicating a degree of deterioration of a consumable, a time at which a predetermined period (first period) is elapsed since the start of the measurement. Note that, in the period from the start to the end of the measurement, a period from the reference time to the end of the measurement is referred to as a second period.

The term "period" used herein is, however, not limited to time, and includes a concept equivalent to time. The consumable is a battery, and a reference time refers to a number of cycles in which a number of cycles from the measurement start time becomes a predetermined value.

The training data 121 generated by the training data generating device 120 is stored in a training data storage part 133 of the training device 130.

A training program is installed in the training device 130, and the training device 130 works as a Gaussian process regression model 131 and a comparison/change part 132 when the program is executed.

The Gaussian process regression model 131 is a nonparametric probability model, and also is a model capable of outputting prediction data (a predicted attenuation factor after a reference time in the present embodiment) and a variance of the prediction data (a width of a 95% confidence interval in the present embodiment). In the present embodiment, the Gaussian process regression model 131 outputs output data (the predicted attenuation factor after the reference time) when input data (a feature measured from the measurement start time to the reference time) of the training data 121 is input.

The comparison/change part 132 updates a model parameter for the Gaussian process regression model 131 so that the output data matches the ground-truth data (an attenuation factor of the characteristic data after the reference time with reference to the characteristic data at the reference time) of the training data 121.

Note that the updated model parameter is held in a trained Gaussian process regression model 332 (described in detail later) and used in a prediction phase.

<Specific Example of Processing of Training Data Generating Device>

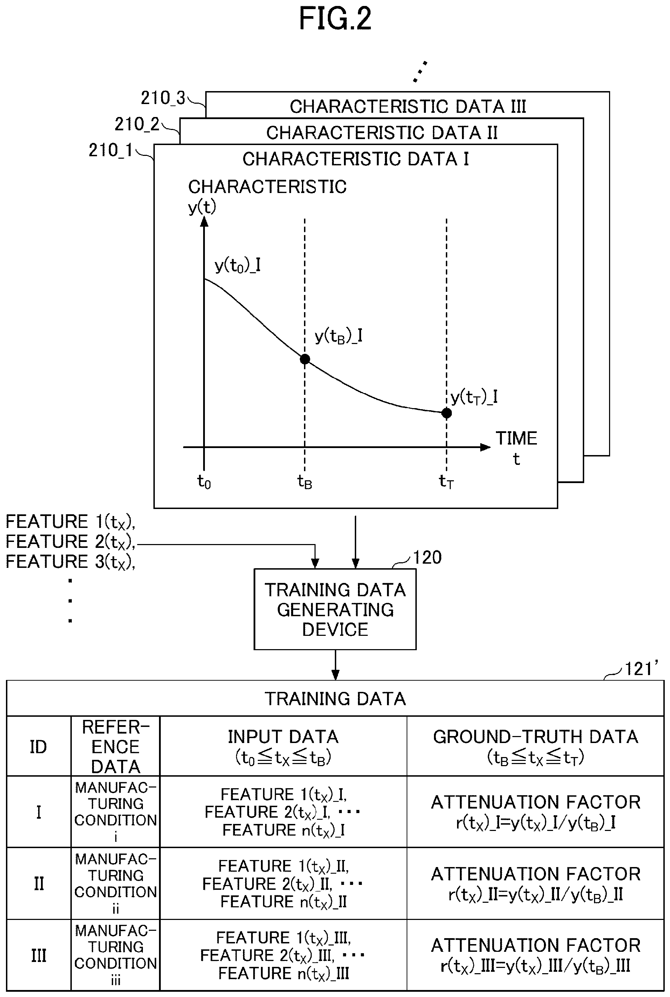

Next, a specific example of processing of the training data generating device 120 constituting the prediction data display system 100 in the training phase will be described. FIG. 2 is a diagram illustrating a specific example of the processing of the training data generating device.

In FIG. 2, reference numerals 210_1, 210_2, 210_3, ... illustrate specific examples of the characteristic data I, II, III, ..., respectively. As illustrated in FIG. 2, in the figures of the characteristic data I, II, III, ..., the horizontal axis represents a time t, and the vertical axis represents characteristic data $y(t)$ at the time t.

In the reference numeral 210_1, $y(t_0)\_I$ illustrates the characteristic data for the consumable I at the measurement start time (time $= t_0$), $y(t_B)\_I$ illustrates the characteristic data for the consumable I at the reference time (time $= t_B$), and $y(t_T)\_I$ illustrates the characteristic data for the consumable I at the end of measurement (time $= t_T$).

A feature $1(t_X)$, a feature $2(t_X)$, a feature $3(t_X)$, ... each represent a feature used for generating the characteristic data $y(t_X)\_I$ and the like at a time $t_X$ (where $t_0 \leq t_X \leq t_T$).

According to the specific example of FIG. 2, the training data generating device 120 generates training data 121' based on the following:

·the characteristic data I, II, III, ... illustrated in the reference numerals 210_1, 210_2, 210_3, ..., respectively; and
·the feature $1(t_X)$, feature $2(t_X)$, feature $3(t_X)$, ....

The training data 121' is a specific example of the training data 121 illustrated in FIG. 1, and the following in association with "ID" = I are input:

- "Reference data": manufacturing condition i;
- "Input data": feature $1(t_X)\_I$, feature $2(t_X)\_I$, ..., feature $n(t_X)\_I$; and
- "Ground-truth data": attenuation factor $r(t_X)\_I = y(t_X)\_I/y(t_B)\_I$.

Similarly, the following in association with "ID" = II are input:

- "Reference data": manufacturing condition ii;
- "Input data": feature $1(t_X)$_II, feature $2(t_X)$_II, ..., feature $n(t_X)$_II; and
- "Ground-truth data": attenuation factor $r(t_X)$_II = $y(t_X)$_II/$y(t_B)$_II.

Similarly, the following in association with "ID" = III are input:

- "Reference data": manufacturing condition iii;
- "Input data": feature $1(t_X)$_III, feature $2(t_X)$_III, ..., feature $n(t_X)$_III; and
- "Ground-truth data": attenuation factor $r(t_X)$_III = $y(t_X)$_III/$y(t_B)$_III.

<System Configuration of Prediction Data Display System and Functional Configuration of Prediction Data Display Device in Prediction Phase>

Next, a system configuration of the prediction data display system and a functional configuration of the prediction data display device constituting the prediction data display system in the prediction phase will be described.

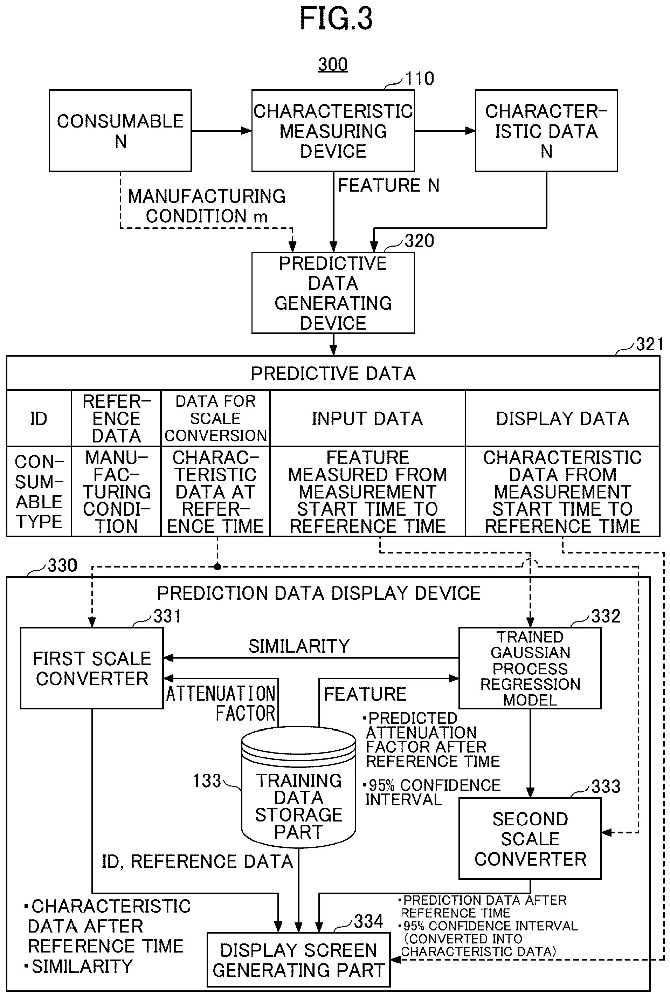

FIG. 3 is a diagram illustrating a system configuration example of the prediction data display system and a functional configuration example of the prediction data display device in the prediction phase. As illustrated in FIG. 3, a prediction data display system 300 in the prediction phase includes the characteristic measuring device 110, a predictive data generating device 320, and a prediction data display device 330.

The characteristic measuring device 110 has been described with reference to FIG. 1, thus the description thereof is omitted here. Note that, in the prediction phase, the characteristic measuring device 110 measures a feature N as information on characteristic data N for a consumable N to be predicted (a second consumable, a battery manufactured under a manufacturing condition m). The characteristic measuring device 110 also generates the characteristic data N based on the measured feature N. More specifically, as the battery manufactured under the manufacturing condition m, which is an example of the consumable, a lithium ion secondary battery that is the same type of the battery used in the generation of the training data described above and that is manufactured under the manufacturing condition m is exemplified.

The predictive data generating device 320 generates predictive data 321 used for a prediction data display process by the prediction data display device 330. As illustrated in FIG. 3, the predictive data 321 includes "ID", "Reference data", "Data for scale conversion", "Input data", and "Display data" as information items, and the following contents are input as the respective information items:

- "ID" : types of consumable to be predicted;
- "Reference data": manufacturing conditions of the consumable to be predicted;
- "Data for scale conversion": characteristic data at the reference time;
- "Input data": features measured from the measurement start time to the reference time; and
- "Display data": characteristic data from the measurement start time to the reference time.

The predictive data 321 generated by the predictive data generating device 320 is notified to the prediction data display device 330.

A prediction data display program is installed in the prediction data display device 330, and when the prediction data display program is executed, the prediction data display device 330 works as follows:

- a first scale converter 331;
- the trained Gaussian process regression model 332;
- a second scale converter 333; and
- a display screen generating part 334.

The first scale converter 331 calculates the characteristic data (scale-converted characteristic data) after the reference time for each consumable (consumable I, II, III, ...), based on the following:

- the characteristic data at the reference time included in "Data for scale conversion" in the predictive data 321; and
- the attenuation factor included in "Ground-truth data" in the training data 121.

The first scale converter 331 also determines a display appearance with which the characteristic data after the reference time for each consumable is displayed based on a similarity of the consumable notified from the trained Gaussian process regression model 332. The first scale converter 331 also notifies the display screen generating part 334 of the characteristic data after the reference time for each consumable for which the display appearance has been determined, together with notifying the similarity.

The trained Gaussian process regression model 332 is an example of a prediction part, and holds the model parameter updated by performing the training process on the Gaussian process regression model 131 in the training phase.

In the above description, the Gaussian process regression model is used as an example of the regression model. The present embodiment is, however, not limited thereto. For example, another regression model such as a Poisson process regression model may be used as long as the model can output prediction data and a 95% confidence interval of the prediction data.

When the feature measured from the measurement start time to the reference time included in "Input data" in the predictive data 321 is input, the trained Gaussian process regression model 332 performs the following:

·a process of calculating, for each consumable, a similarity between the input feature and the feature measured from the measurement start time to the reference time, which is included in "Input data" in the training data 121, to notify the first scale converter 331 of the calculated similarity; and
·a process of calculating the predicted attenuation factor after the reference time for the consumable N to be predicted, using the calculated similarity of the consumable, calculating a 95% confidence interval when the predicted attenuation factor after the reference time for the consumable N to be predicted is calculated, and notifying the second scale converter 333 of the calculated predicted attenuation factor and the calculated 95% confidence interval.

The second scale converter 333 predicts characteristic data (prediction data) after the reference time for the consumable to be predicted, based on the following:

·the characteristic data at the reference time included in "Data for scale conversion" in the predictive data 321; and
·the predicted attenuation factor after the reference time notified from the trained Gaussian process regression model 332.

The second scale converter 333 also calculates a 95% confidence interval converted into the characteristic data based on the characteristic data at the reference time included in "Data for scale conversion" in the predictive data 321 and the 95% confidence interval notified from the trained Gaussian process regression model 332.

The second scale converter 333 also notifies the display screen generating part 334 of the predicted characteristic data (the prediction data) after the reference time for the consumable to be predicted and the calculated 95% confidence interval (converted into the characteristic data).

The display screen generating part 334 is an example of a display part, and generates a display screen. At least the following are displayed on the display screen generated by the display screen generating part 334:

·the characteristic data from the measurement start time to the reference time included in "Display data" in the predictive data 321;
the prediction data after the reference time for the consumable N notified from the second scale converter 333;
·the 95% confidence interval (converted into the characteristic data) for the consumable N notified from the second scale converter 333; and
·the characteristic data after the reference time for each consumable (consumable I, II, III, ...) notified from the first scale converter 331.

At such a time, the display screen generating part 334 displays the characteristic data after the reference time notified from the first scale converter 331 in the display appearance determined by the first scale converter 331.

As described above, when the prediction data display device 330 displays the prediction data predicted using the machine learning model for the consumable to be predicted, the characteristic data generated based on the training data used in the training process of the machine learning model is also displayed. At such a time, the prediction data display device 330 displays the characteristic data generated based on the training data with the display appearance determined in accordance with the similarity of the feature. This allows the user to compare the prediction data for the consumable to be predicted with the past characteristic data whose display appearance has been changed in accordance with the similarity. As a result, the user can more easily determine whether the prediction data is correct or not.

<Specific Example of Processing of Predictive Data Generating Device>

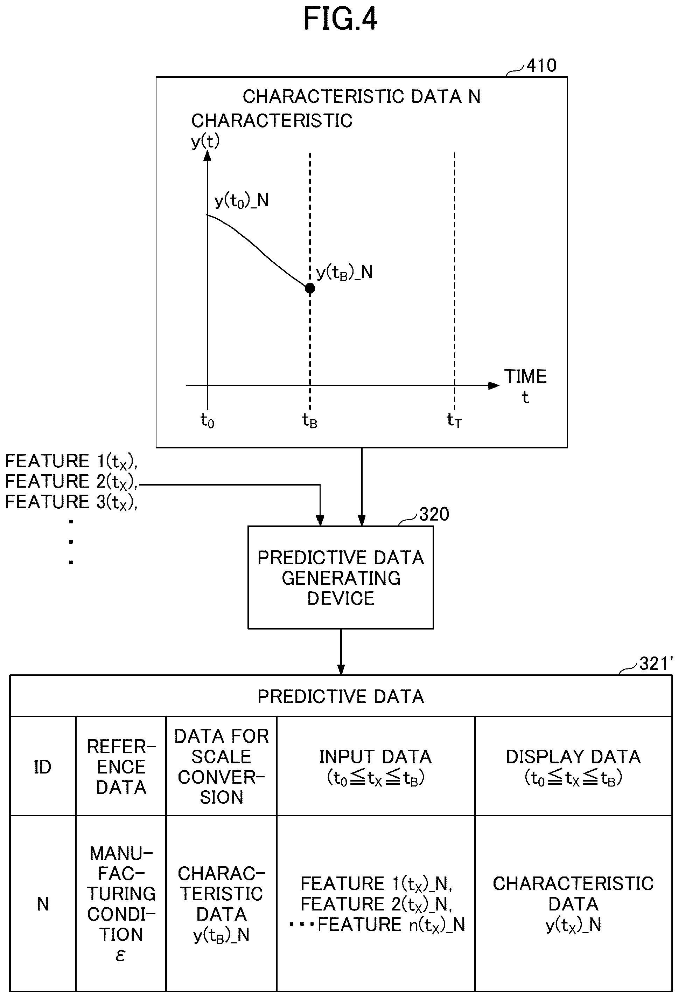

Next, a specific example of processing of the predictive data generating device 320 constituting the prediction data display system 300 in the prediction phase will be described. FIG. 4 is a diagram illustrating a specific example of the processing of the predictive data generating device.

In FIG. 4, a reference numeral 410 illustrates a specific example of the characteristic data N. As illustrated in in FIG. 4, in the figure of the characteristic data N, the horizontal axis represents the time t, and the vertical axis represents the characteristic data $y(t)$ for the consumable N to be predicted at the time t.

In the reference numeral 410, $y(t_0)\_N$ illustrates characteristic data for the consumable N at the measurement start time (time = $t_0$), and $y(t_B)\_N$ illustrates characteristic data for the consumable N at the reference time (time = $t_B$).

The feature $1(t_X)$, the feature $2(t_X)$, the feature $3(t_X)$, ... each represent the feature used to generate characteristic data $y(t_X)\_N$ at the time $t_X$ (where $t_0 \leq t_X \leq t_B$).

According to the specific example of FIG. 4, the predictive data generating device 320 generates predictive data 321' based on the characteristic data N illustrated in the reference numeral 410 and the feature $1(t_X)$, the feature $2(t_X)$, the feature $3(t_X)$, ....

The predictive data 321' is a specific example of the predictive data 321 illustrated in FIG. 3, and the following in association with "ID" = N are input:

- "Reference data":  manufacturing condition $\varepsilon$;
- "Data for scale conversion":  characteristic data $y(t_B)\_N$;
- "Input data":  feature 1 $(t_X)\_N$, feature 2 $(t_X)\_N$, ..., feature $n(t_X)\_N$; and
- "Display data":  characteristic data $y(t_X)\_N$.

<Description of Training device and Prediction Data Display Device>

Next, the training device 130 constituting the prediction data display system 100 in the training phase and the prediction data display device 330 constituting the prediction data display system 300 in the prediction phase will be described in detail.

(1) Hardware Configurations of Training Device and Prediction Data Display Device 330

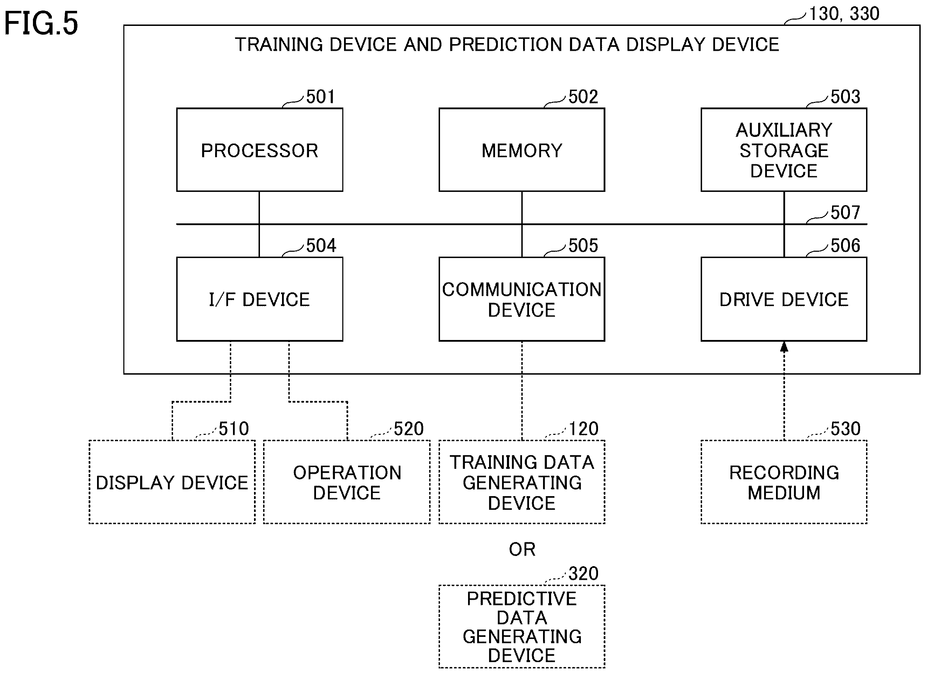

Hardware configurations of the training device 130 and the prediction data display device 330 will be described. FIG. 5 is a diagram illustrating a hardware configuration example of the training device and the prediction data display device. The training device 130 and the prediction data display device 330 have the same hardware configuration, and thus will be collectively described with reference to FIG. 5.

As illustrated in FIG. 5, the training device 130 and the prediction data display device 330 include a processor 501, a memory 502, an auxiliary storage device 503, an interface (I/F) device 504, a communication device 505, and a drive device 506. The hardware components of each of the training device 130 and the prediction data display device 330 are connected to each other via a bus 507.

The processor 501 includes various computing devices such as a central processing unit (CPU) and a graphics processing unit (GPU). The processor 501 reads various programs (for example, a training program, a prediction data display program, and the like) on the memory 502 and executes the programs.

The memory 502 includes a main storage device such as a read only memory (ROM) and a random access memory (RAM). The processor 501 and the memory 502 form what is known as a computer, and the computer implements various functions by the processor 501 executing various programs read out on the memory 502.

The auxiliary storage device 503 stores various programs and various types of data used when the various programs are executed by the processor 501. For example, the training data storage part 133 described above is achieved in the auxiliary storage device 503.

The I/F device 504 is a connection device connected to a display device 510 and an operation device 520, which are external devices. The communication device 505 is a communication device for communicating with an external device (for example, the training data generating device 120 or the predictive data generating device 320) via a network.

The drive device 506 is a device for setting a recording medium 530. The recording medium 530 includes a medium for optically, electrically, or magnetically recording information, such as a CD-ROM, a flexible disk, or a magneto-optical disk. The recording medium 530 may include a semiconductor memory or the like that electrically records information, such as a ROM or a flash memory.

The various programs installed in the auxiliary storage device 503 are installed by, for example, setting the distributed recording medium 530 in the drive device 506 and reading out the various programs recorded in the recording medium 530 by the drive device 506. Alternatively, the various programs installed in the auxiliary storage device 503 may be installed by being downloaded over a network via the communication device 505.

(2) Specific Example of Processing of First Scale Converter of Prediction Data Display Device

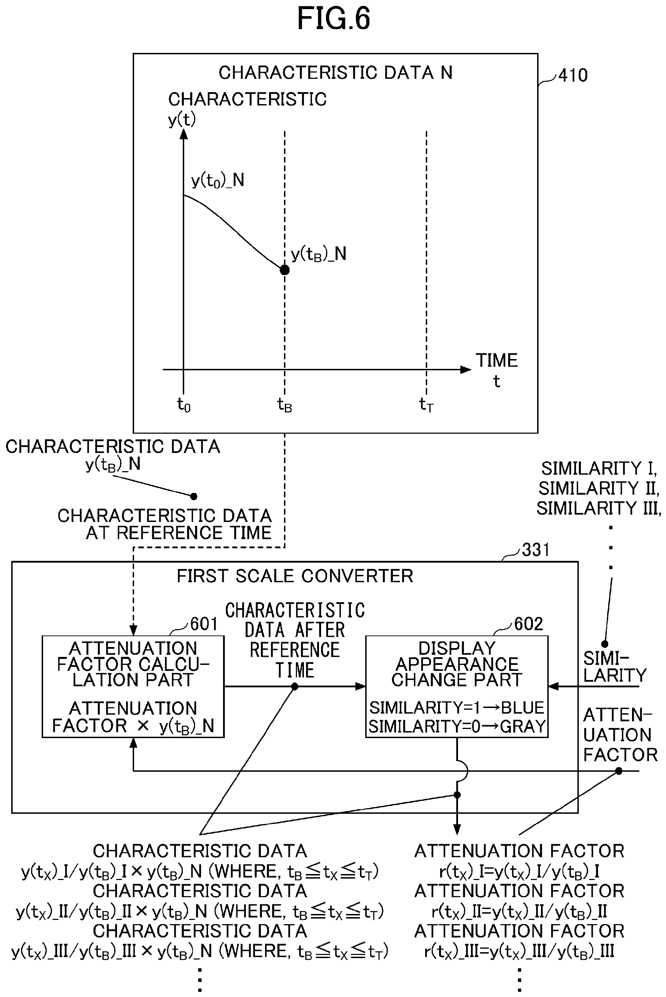

Next, a specific example of processing of the first scale converter 331 of the prediction data display device 330 will be described. FIG. 6 is a diagram illustrating a specific example of the processing of the first scale converter of the prediction data display device.

As illustrated in FIG. 6, the first scale converter 331 includes an attenuation factor calculation part 601 and a display appearance change part 602.

The attenuation factor calculation part 601 acquires the characteristic data $y(t_B)\_N$ as the characteristic data at the reference time, and multiplies the acquired characteristic data by the attenuation factor after the reference time for each consumable (consumable I, II, III, ...) to obtain the characteristic data after the reference time for each consumable. The example of FIG. 6 illustrates a state in which the characteristic data after the reference time is calculated for each consumable by multiplying the characteristic data at the reference time by the respective attenuation factors. The attenuation factors for consumables I, II, III, ..., are represented as follows:

- 

$$r(t_x)\_I = y(t_x)\_I/y(t_B)\_I$$

(where $t_B \leq t_x \leq t_T$);

- 

$$r(t_x)\_II = y(t_x)\_II/y(t_B)\_II$$

(where $t_B \leq t_x \leq t_T$);

- 

$$r(t_x)\_III = y(t_x)\_III/y(t_B)\_III$$

(where $t_B \leq t_x \leq t_T$);

The calculated characteristic data after the reference time for each consumable is represented as follows:

the characteristic data after the reference time for the consumable I

$$\{y(t_X)\_I/y(t_B)\_I\} \times y(t_B)\_N$$

(where $t_B \leq t_X \leq t_T$);

the characteristic data after the reference time for the consumable II

$$\{y(t_X)\_II/y(t_B)\_II\} \times y(t_B)\_N$$

(where $t_B \leq t_X \leq t_T$);

the characteristic data after the reference time for the consumable III

$$\{y(t_X)\_III/y(t_B)\_III\} \times y(t_B)\_N$$

(where $t_B \leq t_X \leq t_T$);

The display appearance change part 602 determines a display appearance with which the characteristic data after the reference time for each consumable (consumable I, II, III, ...) is displayed based on a similarity of the consumable notified from the trained Gaussian process regression model 332. The example of FIG. 6 illustrates a state in which a similarity I, a similarity II, a similarity III, ... are notified from the trained Gaussian process regression model 332 as the similarities for the consumables I, II, III, ..., respectively.

The example of FIG. 6 also illustrates that, in a case where the similarity for the consumable notified from the trained Gaussian process regression model 332 is "1", the display appearance change part 602 determines the display color for the graph of the corresponding characteristic data after the reference time to be blue.

The example of FIG. 6 illustrates that, in a case where the similarity for the consumable notified from the trained Gaussian process regression model 332 is "0", the display appearance change part 602 determines the display color for the graph of the corresponding characteristic data after the reference time to be gray.

Note that, in a case where the similarity for the consumable notified from the trained Gaussian process regression model 332 is larger than "0" and smaller than "1", the display appearance change part 602 determines the display color for the graph of the corresponding characteristic data after the reference time to be an intermediate color between gray and blue.

For example, in a case where the similarity is close to "0", the display appearance change part 602 determines the display color for the graph of the corresponding characteristic data after the reference time to be a color close to gray among the colors in the gray to blue gradation. In a case where the similarity is close to "1", the display appearance change part 602 determines the display color for the graph of the corresponding characteristic data after the reference time to be a color close to blue among the colors in the gray to blue gradation.

The method of determining the display color by the display appearance change part 602 is, however, not limited thereto. For example, the display color may be determined to be gray in a case where the similarity is less than a predetermined threshold value, and may be determined to be blue in a case where the similarity is equal to or greater than the predetermined threshold value.

(3) Specific Example of Processing of Trained Gaussian Process Regression Model of Prediction Data Display Device

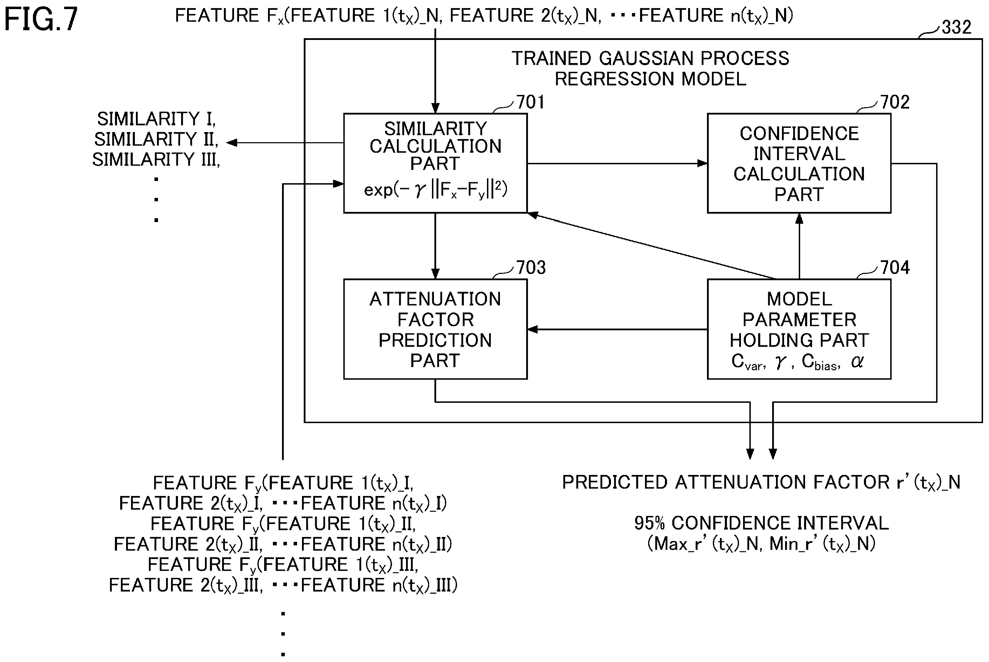

Next, a specific example of processing of the trained Gaussian process regression model 332 of the prediction data display device 330 will be described. FIG. 7 is a diagram illustrating a specific example of the processing of the trained Gaussian process regression model of the prediction data display device.

As illustrated in FIG. 7, the trained Gaussian process regression model 332 includes a similarity calculation part 701, a confidence interval calculation part 702, an attenuation factor prediction part 703, and a model parameter holding part 704.

The similarity calculation part 701 receives the features measured from the measurement start time to the reference time and included in "Input data" in the predictive data 321 and the features measured from the measurement start time to the reference time and included in "Input data" in the training data 121.

The example of FIG. 7 illustrates a state in which the features measured from the measurement start time to the reference time and included in "Input data" in the predictive data 321 as follows are input:

- feature $F_y$(feature 1$(t_X)$_N, feature 2 $(t_X)$_N, ..., feature n$(t_X)$_N) (where $t_0 \leq t_X \leq t_B$).

The example of FIG. 7 also illustrates a state in which the features measured from the measurement start time to the reference time and included in "Input data" in the training data 121 as follows are input:

- feature $F_y$(feature 1$(t_X)$_I, feature 2$(t_X)$_I, ..., feature n$(t_X)$_I) (where $t_0 \leq t_X \leq t_B$) ;
- feature $F_y$(feature 1$(t_X)$_II, feature 2$(t_X)$_II, ..., feature n$(t_X)$_II) (where $t_0 \leq t_X \leq t_B$) ;
- feature $F_y$(feature 1$(t_X)$_III, feature 2$(t_X)$_III, ..., feature n $(t_X)$_III) (where $t_0 \leq t_X \leq t_B$) ;

The similarity calculation part 701 also calculates the similarity for each consumable (consumable I, II, III, ...) with the following Equation 1 based on the input feature $F_x$ and feature $F_y$.

[Math. 1]

$$\text{Similarity} = \exp\left(-\gamma \| F_x - F_y \|^2\right)$$

$$(\text{Equation 1})$$

Note that $\gamma$ is a model parameter calculated when the training process is performed in the training phase and held in the model parameter holding part 704.

The similarity calculation part 701 notifies the first scale converter 331 of the calculated similarity for each consumable. The example of FIG. 7 illustrates a state in which the first scale converter 331 is notified of the similarity I as the similarity for the consumable I, the similarity II as the similarity for the consumable II, and the similarity III as the similarity for the consumable III.

The confidence interval calculation part 702 calculates a 95% confidence interval for the predicted attenuation factor to be calculated by the attenuation factor prediction part 703 using the similarity calculated for each consumable (consumable I, II, III, ...) by the similarity calculation part 701. The example of FIG. 7 illustrates a state in which (Max_r'($t_X$) _N, Min_r'($t_X$)_N) is calculated as the 95% confidence interval.

The attenuation factor prediction part 703 calculates the predicted attenuation factor after the reference time for the consumable N to be predicted by using the similarity calculated for each consumable (consumable I, II, III, ...) by the similarity calculation part 701. The example of FIG. 7 illustrates a state in which a predicted attenuation factor r' ($t_X$)_N is calculated as the predicted attenuation factor after the reference time for the consumable N to be predicted. Note that the attenuation factor prediction part 703 calculates the predicted attenuation factor r'($t_X$)_N by calculating a kernel expressed by the following Equation 2, for example.

[Math. 2]

$$\text{Kernel } K\ (F_x,\ F_y)\ = C_{var} \times exp\ (-\gamma \| F_x - F_y \|^2)\ + C_{bias} + \alpha \times \delta_{xy}$$

(Equation 2)

Note that $C_{var}$, $C_{bias}$, and $\alpha$ are model parameters calculated when the training process is performed in the training phase and held in the model parameter holding part 704.

The model parameter holding part 704 holds the model parameters calculated when the training process is performed in the training phase. The example of FIG. 7 illustrates that the model parameter holding part 704 holds at least $C_{var}$, $\gamma$, $C_{bias}$, and $\alpha$ as the model parameters.

Note that, in the similarity calculation part 701, the features to be input as the features $F_x$ and $F_y$ may be converted and used. For example, values obtained by performing a dimension compression process such as principal component analysis, independent component analysis, or Kernel PCA may be used.

(4) Specific Example of Processing of Second Scale Converter of Prediction Data Display Device

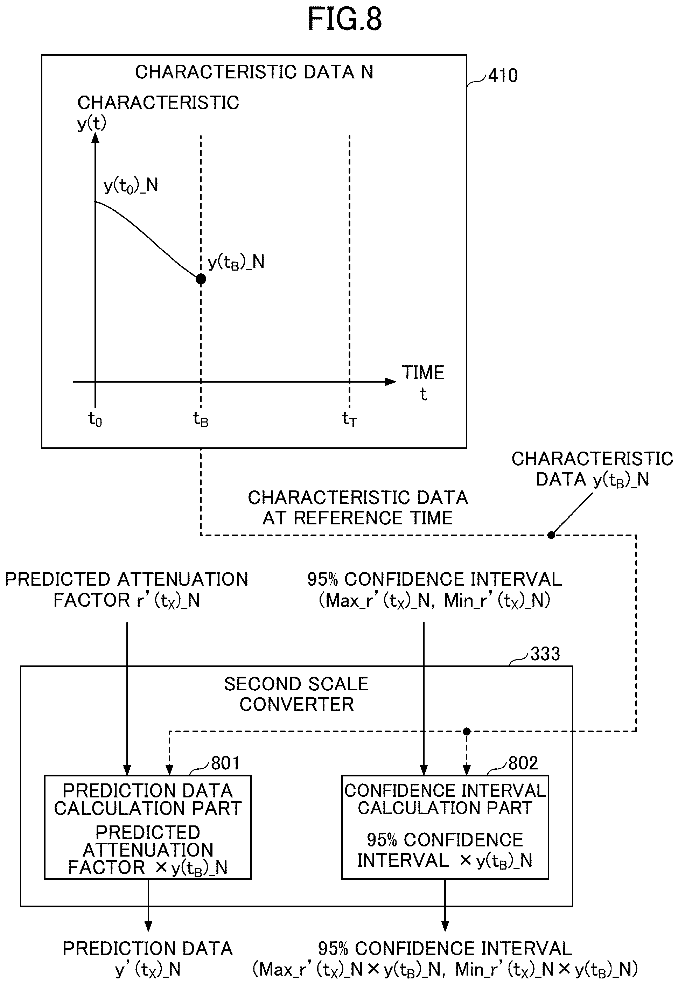

Next, a specific example of processing of the second scale converter 333 of the prediction data display device will be described. FIG. 8 is a diagram illustrating a specific example of the processing of the second scale converter of the prediction data display device.

As illustrated in FIG. 8, the second scale converter 333 includes a prediction data calculation part 801 and a confidence interval calculation part 802.

The prediction data calculation part 801 acquires the characteristic data y($t_B$)_N as the characteristic data at the reference time, and multiplies the acquired characteristic data y($t_B$)_N by the predicted attenuation factor for the consumable N to be predicted, thereby predicting the prediction data after the reference time for the consumable N to be predicted. The example of FIG. 8 illustrates a state in which the prediction data after the reference time is predicted by multiplying the acquired characteristic data by r' ($t_X$)_N as the predicted attenuation factor for the consumable N to be predicted. The prediction data is predicted as follows:

- prediction data y' ($t_X$)_N = y($t_B$)_N $\times$ r' ($t_X$)_N.

The confidence interval calculation part 802 acquires the characteristic data y($t_B$)_N as the characteristic data at the reference time, and multiplies the acquired characteristic data by the 95% confidence interval for the predicted attenuation factor to calculate the 95% confidence interval converted into the characteristic data. The example of FIG. 8 illustrates a state in which the 95% confidence interval converted into the characteristic data is calculated by multiplying the acquired characteristic data by the 95% confidence interval for the predicted attenuation factor. The 95% confidence interval for the predicted attenuation factor is expressed as follows:

- 95% confidence interval (Max_r'($t_X$)_N, Min_r'($t_X$)_N). The 95% confidence interval converted into the characteristic data is expressed as follows:
- 95% confidence interval (Max_r'($t_X$)_N $\times$ y($t_B$)_N, Min_r'($t_X$)_N $\times$ y($t_B$)_N) .

Note that, in a case where the prediction data predicted by the prediction data calculation part 801 and the 95% confidence interval (converted into the characteristic data) calculated by the confidence interval calculation part 802 are graphed, a plurality of methods to graph are exemplified.

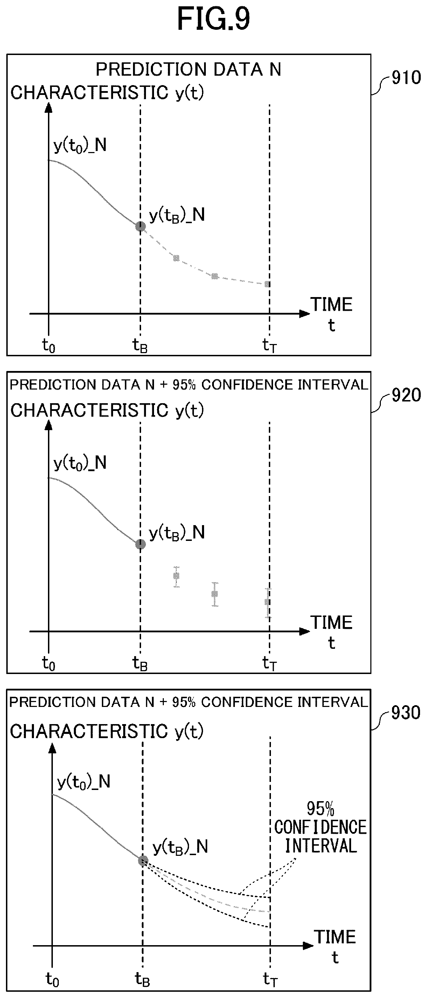

FIG. 9 is a diagram illustrating examples of a graph of the prediction data and the 95% confidence interval. In the examples of FIG. 9, for convenience of explanation, the characteristic data $y(t_X)\_N$ (where $t_0 \leq t_X \leq t_B$), which is the display data, is also illustrated (see the red colored line in FIG. 9).

In FIG. 9, a graph 910 is a line graph illustrating only three predicted times plotted as the prediction data after the reference time and a dotted line connecting the respective plots.

In FIG. 9, a graph 920 is a box plot graph in which only three predicted times are plotted as the prediction data after the reference time, together with the respective 95% confidence intervals (see green colored box plots in FIG. 9).

In FIG. 9, a graph 930 is a curved graph illustrating the prediction data after the reference time, which is predicted every hour, together with the respective 95% confidence intervals (see green colored dotted lines in FIG. 9).

Note that, the graphs 910 to 930 are examples of graphing, and a graph may be created by methods other than the methods used for the graphs 910 to 930.

(5) Specific Example of Processing of Display Screen Generating part of Prediction Data Display Device

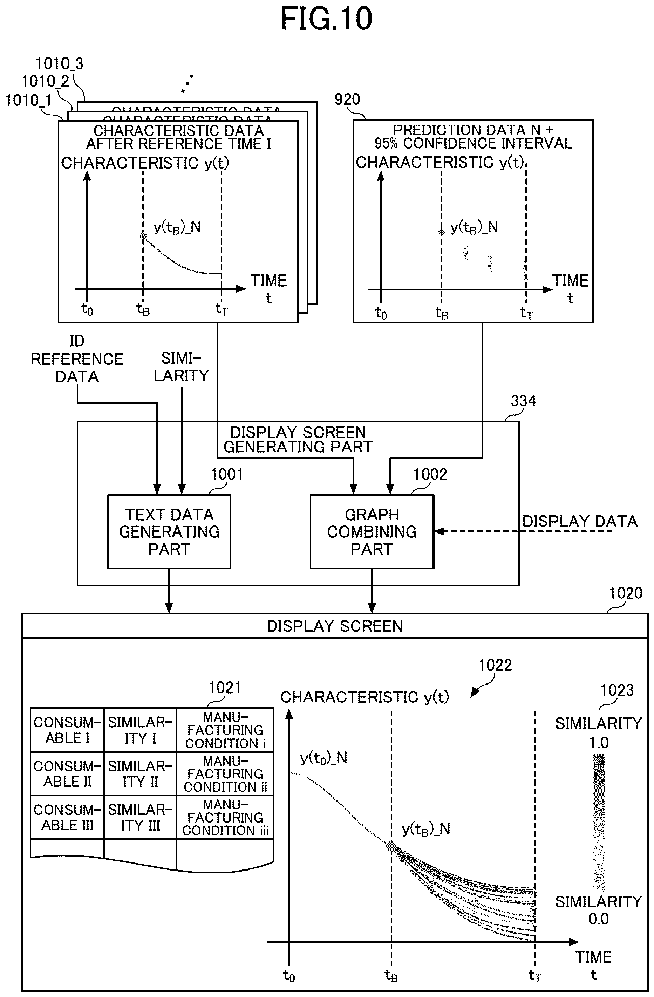

Next, a specific example of processing of the display screen generating part 334 of the prediction data display device 330 will be described. FIG. 10 is a first diagram illustrating a specific example of the processing of the display screen generating part of the prediction data display device. In FIG. 10, reference numerals 1010_1, 1010_2, 1010_3, ... each illustrates a graph of the characteristic data after the reference time for the respective consumables notified from the first scale converter 331 in the determined display color. The characteristic data for each consumable is as follows:

- characteristic data after the reference time for the consumable I $\{y(t_X)\_I/y(t_B)\_I\} \times y(t_B)\_N$ (where $t_B \leq t_X \leq t_T$);
- the characteristic data after the reference time for the consumable II $\{y(t_X)\_II/y(t_B)\_II\} \times y(t_B)\_N$ (where $t_B \leq t_X \leq t_T$);
- the characteristic data after the reference time for the consumable III $\{y(t_X)\_III/y(t_B)\_III\} \times y(t_B)\_N$ (where $t_B \leq t_X \leq t_T$);

In FIG. 10, a reference numeral 920 is a graph of the following for the consumable N to be predicted:

- prediction data after the reference time $y'(t_X)\_N = y(t_B)\_N \times r'(t_X)\_N$; and
- 95% confidence interval converted into the characteristic data $(Max\_r'(t_X)\_N \times y(t_B)\_N, Min\_r'(t_X)\_N \times y(t_B)\_N)$.

As illustrated in FIG. 10, the display screen generating part 334 includes a text data generating part 1001 and a graph combining part 1002.

The text data generating part 1001 reads "ID" and "Reference data" in the training data 121 stored in the training data storage part 133. The text data generating part 1001 also acquires the similarities (similarity I, II, III, ...) for the respective consumables (consumable I, II, III, ...) from the first scale converter 331.

Furthermore, the text data generating part 1001 generates a text table 1021 in which the read "ID" and "Reference data" are associated with the acquired similarity, and displays the table on a display screen 1020.

The graph combining part 1002 acquires the graph of the characteristic data from the measurement start time to the reference time for the consumable N to be predicted from "Display data" in the predictive data 321. The graph combining part 1002 also acquires the graph (reference numeral 920) of the prediction data and the respective 95% confidence intervals for the consumable N to be predicted from the second scale converter 333. The graph combining part 1002 also acquires the graphs (reference numerals 1010_1, 1010_2, 1010_3, ...) of the characteristic data after the reference time for respective consumables (consumables I, II, III, ...) from the first scale converter 331.

The graph combining part 1002 generates a combined graph 1022 by combining the acquired graphs, and displays the combined graph on the display screen 1020.

Note that, in the combined graph 1022, a red line represents the graph of the characteristic data from the measurement start time to the reference time for the consumable N to be predicted. In the combined graph 1022, a green box plot graph is the graph of the prediction data and the respective 95% confidence intervals for the consumable N to be predicted (reference numeral 920). Furthermore, in the combined graph 1022, blue to gray lines represent the graph (reference numeral 1010_1, 1010_2, 1010_3, ...) of the characteristic data for the respective consumables (consumable I, II, III, ...) after the reference time, respectively. A color bar 1023 represents the relationship between the display color of the characteristic data after the reference time for each consumable and the similarity for each consumable (for each color, see the colored FIG. 10).

As described above, in the present embodiment, when the graph (green box plot graph) of the prediction data is displayed, the graphs (blue to gray lines) of the characteristic data for the respective consumables generated based on the training data used in the training process of the Gaussian process regression model are also displayed. At such a time, the graph after the reference time is displayed after being subjected to scale conversion according to the characteristic data at the reference time. This allows the user to compare the data for the consumable to be predicted with the past characteristic data that is color-coded according to the similarity. As a result, the user can easily determine whether the prediction data is correct or not.

In the case of the example of FIG. 10, the graph of the prediction data (green box plot graph) is in a range that substantially overlaps the graph of the blue characteristic data among the graphs of the characteristic data for each consumable, and the user can therefore determine that the prediction data is correct.

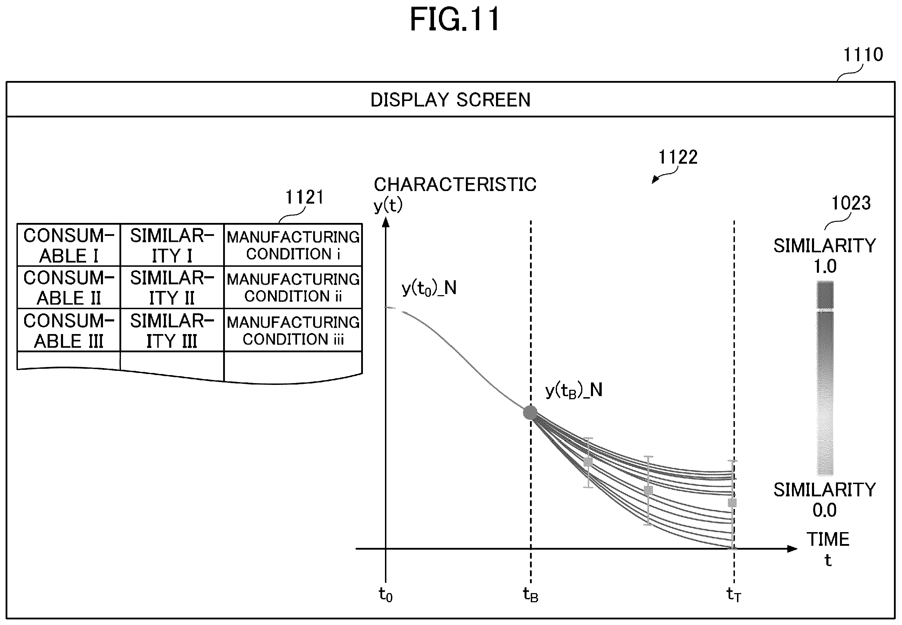

FIG. 11 is a second diagram illustrating a specific example of the processing of the display screen generating part of the prediction data display device. In a case of the example of a display screen 1110 of FIG. 11, the similarity between the feature for the consumable N to be predicted and the feature for each consumable (consumable I, II, III, ...) are low. Therefore, in a combined graph 1122, the graph of the prediction data (green box plot graph) is within the range of the graph of the gray characteristic data. As a result, the user can determine that the prediction data is highly likely to be incorrect.

Such a determination of whether the prediction data is correct or not is particularly effective in a case where a new consumable is a prediction target.

<Flow of Processing in Prediction Data Display System>

Next, a flow of processing in the prediction data display systems 100 and 300 will be described.

(1) Flow of Training process in Prediction Data Display System in Training Phase

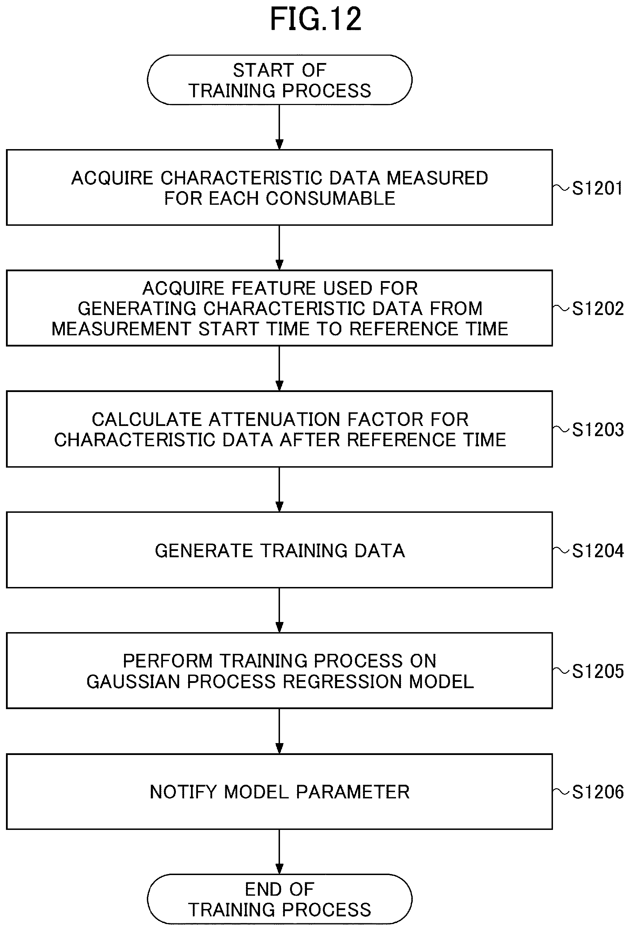

First, a flow of the training process in the prediction data display system 100 in the training phase will be described. FIG. 12 is a flowchart illustrating the flow of the training process.

In step S1201, the characteristic measuring device 110 acquires characteristic data generated for each consumable.

In step S1202, the training data generating device 120 acquires a feature used for generating the characteristic data from the measurement start time to the reference time for each consumable.

In step S1203, the training data generating device 120 calculates an attenuation factor for the characteristic data after the reference time for each consumable.

In step S1204, the training data generating device 120 generates training data.

In step S1205, the training device 130 performs a training process on the Gaussian process regression model with the training data.

In step S1206, the training device 130 notifies the prediction data display device 330 of (model parameters of) the trained Gaussian process regression model generated by performing the training process.

(2) Flow of Prediction Data Display Process in Prediction Data Display System in Prediction Phase

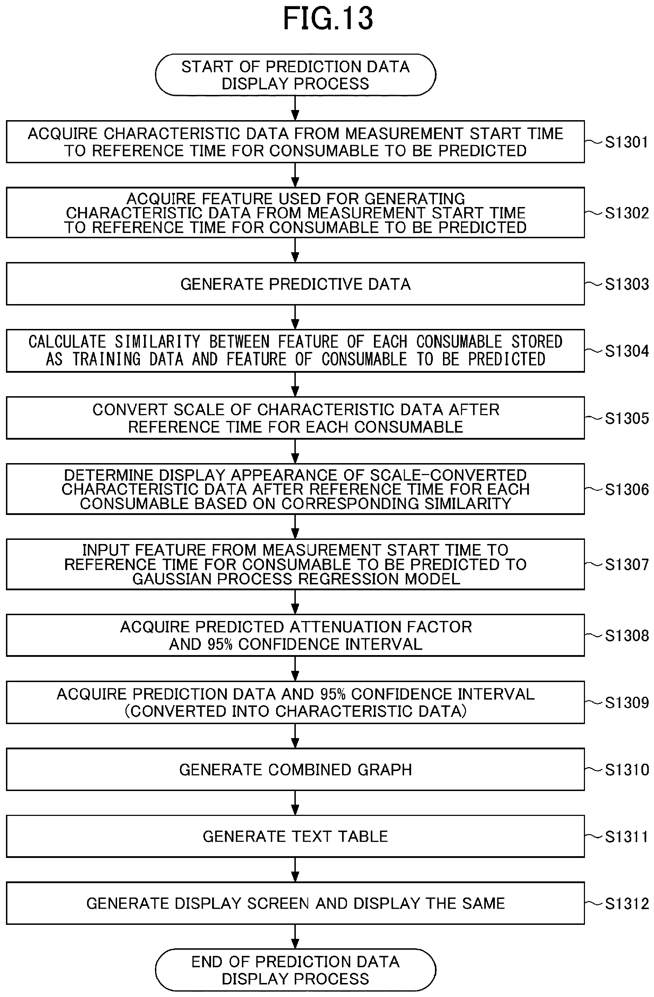

Next, a flow of a prediction data display process in the prediction data display system 300 in the prediction phase will be described. FIG. 13 is a first flowchart illustrating the flow of the prediction data display process.

In step S1301, the predictive data generating device 320 acquires the characteristic data from the measurement start time to the reference time, which has been generated by the characteristic measuring device 110 for a consumable to be predicted.

In step S1302, the predictive data generating device 320 acquires the feature used when the characteristic measuring device 110 generates the characteristic data from the measurement start time to the reference time for the consumable to be predicted.

In step S1303, the predictive data generating device 320 generates predictive data.

In step S1304, the prediction data display device 330 calculates a similarity between the feature for each consumable stored as the training data and the feature for the consumable to be predicted stored as the predictive data.

In step S1305, the prediction data display device 330 converts the scale of the characteristic data after the reference time for each consumable, the characteristic data having been stored as the training data.

In step S1306, the prediction data display device 330 determines a display appearance with which the characteristic data after the reference time for each consumable, on which the scale conversion has been performed, is displayed based on the corresponding similarity.

In step S1307, the prediction data display device 330 inputs the feature from the measurement start time to the reference time for the consumable to be predicted to the trained Gaussian process regression model.

In step S1308, the prediction data display device 330 acquires a predicted attenuation factor and a 95% confidence interval thereof.

In step S1309, the prediction data display device 330 converts the scales of the acquired predicted attenuation factor and 95% confidence interval to obtain prediction data and a 95% confidence interval (converted into the characteristic data).

In step S1310, the prediction data display device 330 generates a combined graph combining the following:

- a graph of the characteristic data from the measurement start time to the reference time for the consumable to be predicted;
- a graph of the prediction data after the reference time and the 95% confidence interval (converted into the characteristic data); and
- a graph of the characteristic data after the reference time for each consumable, the display color of the characteristic data being determined according to the corresponding similarity.

In step S1311, the prediction data display device 330 generates a text table in which the similarity is associated with the consumable type and the manufacturing condition.

In step S1312, the prediction data display device 330 generates a display screen including the combined graph and the text table, and displays the screen.

<Conclusion>

As is clear from the above description, the prediction data display system according to the first embodiment includes:

- generating training data including information (feature) on first characteristic data indicating the degree of deterioration from the measurement start time to the reference time for each consumable as input data and information (attenuation factor) on second characteristic data indicating the degree of deterioration after the reference time for each consumable as ground-truth data;
- generating a trained Gaussian process regression model by performing a training process on a Gaussian process regression model with the generated training data;
- inputting information (feature) on third characteristic data indicating the degree of deterioration from the measurement start time to the reference time for a consumable to be predicted into the trained Gaussian process regression model, and thereby calculating information (predicted attenuation factor) on fourth characteristic data indicating the degree of deterioration after the reference time for the consumable to be predicted; and
- when displaying the fourth characteristic data indicating the degree of deterioration after the reference time for the consumable to be predicted, displaying also the second characteristic data with a display appearance determined in accordance with a similarity between the information (feature) on the first characteristic data and the information (feature) on the third characteristic data.

This enables the user to compare the prediction data for the consumable to be predicted with the past characteristic data whose display appearance has been changed in accordance with the similarity. As a result, the user can easily determine whether the prediction data is correct or not.

That is, when a degree of deterioration of a consumable is predicted using a machine learning model, the present embodiment enables to more easily determine whether or not prediction data is correct.

[Second Embodiment]

In the first embodiment, the user compares the prediction data for the consumable to be predicted with the characteristic data for each consumable included in the training data in a graph form, thereby easily determining whether the prediction data is correct. In a second embodiment, the prediction data for the consumable to be predicted and the characteristic data for each consumable included in training data are quantified using a 95% confidence interval and compared. The second embodiment will be described below, focusing on the differences from the first embodiment.

<Specific Example of Processing of Display Screen Generating Part of Prediction Data Display Device>

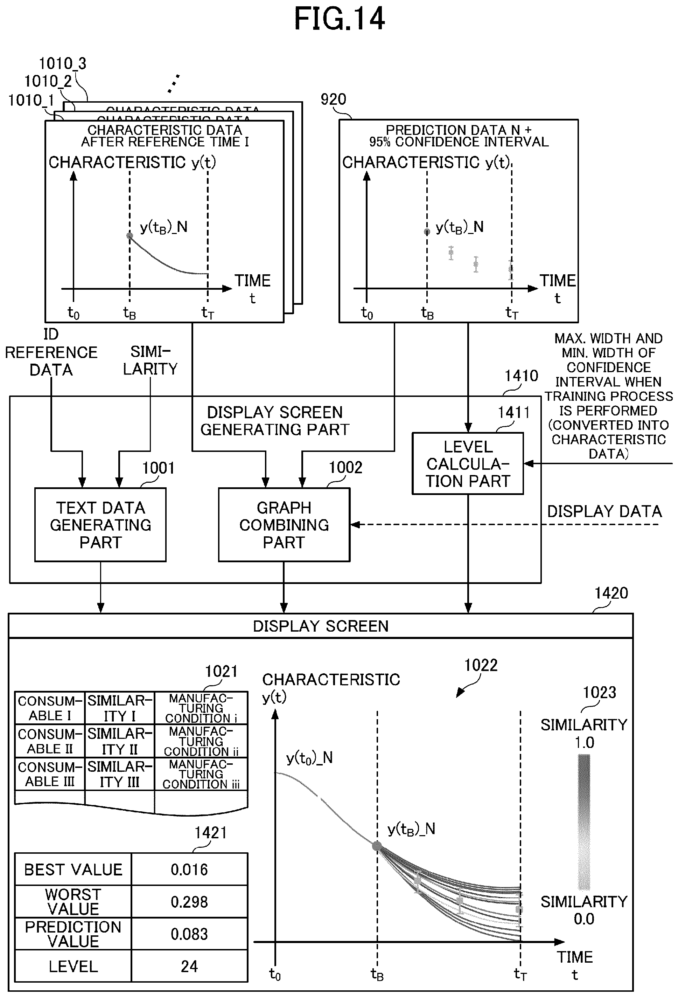

First, a specific example of processing of a display screen generating part of the prediction data display device 330 will be described. FIG. 14 is a third diagram illustrating a specific example of the processing of the display screen generating part of the prediction data display device. The difference from the specific example described with reference to FIG. 10 is that a display screen generating part 1410 of FIG. 14 includes a level calculation part 1411.

The level calculation part 1411 acquires the 95% confidence interval (converted into the characteristic data) for the prediction data from the second scale converter 333, and calculates a width (converted into the characteristic data) of the 95% confidence interval for the prediction data.

The level calculation part 1411 also acquires, as a worst value and a best value, a maximum width and a minimum width (converted into the characteristic data) of the 95% confidence interval calculated when the training process is performed on the Gaussian process regression model 131 with the training data 121, from the training device 130.

The level calculation part 1411 then compares the width (converted into the characteristic data) of the 95% confidence interval for the prediction data with the worst value and the best value acquired from the training device 130. Accordingly, the level calculation part 1411 calculates a level of normality of the width (converted into the characteristic data) of the 95% confidence interval for the prediction data.

In FIG. 14, a data table 1421 is an example of a table containing the level calculated by the level calculation part 1411.

In the data table 1421, "Best value" is the minimum width (converted into the characteristic data) of the 95% confidence interval acquired from the training device 130, and is "0.016" in the example of FIG. 14.

In the data table 1421, "Worst value" is the maximum width (converted into the characteristic data) of the 95% confidence interval acquired from the training device 130, and is "0.298" in the example of FIG. 14.

In the data table 1421, "Prediction value" is the width (converted into the characteristic data) of the 95% confidence interval for the prediction data, and is "0.083" in the example of FIG. 14.

In the data table 1421, "Level" is the level of the degree of normality of the width (converted into the characteristic data) of the 95% confidence interval for the prediction data. In the example of FIG. 14, the level of the degree of normality is {(prediction value ("0.083") - best value ("0.016"))/(worst value ("0.298") - best value ("0.016"))} $\times$ 100 = 24.

<Flow of Prediction Data Display Process in Prediction Data Display System in Prediction Phase>

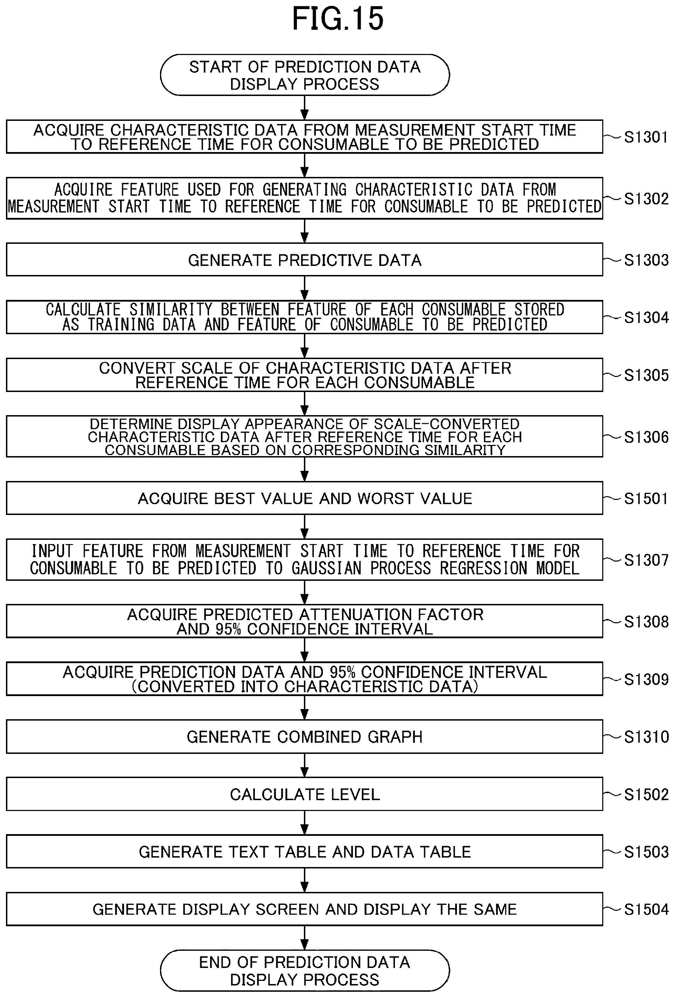

Next, a flow of the prediction data display process in the prediction data display system 300 in the prediction phase will be described. FIG. 15 is a second flowchart illustrating the flow of the prediction data display process. The difference from the flowchart described with reference to FIG. 13 is steps S1501 and S1502 to S1504.

In step S1501, the prediction data display device 330 acquires, as a worst value and a best value, a maximum width and a minimum width (converted into the characteristic data) of the 95% confidence interval calculated when the training process is performed on the Gaussian process regression model in the training phase.

In step S1502, the prediction data display device 330 compares the 95% confidence interval (converted into the characteristic data) acquired in step S1309 with the worst value and the best value acquired in step S1501. Thus, the prediction data display device 330 calculates a level of normality of the width (converted into the characteristic data) of the 95% confidence interval for the prediction data.

In step S1503, the prediction data display device 330 generates a text table in which the similarity is associated with the consumable type and the manufacturing condition. The prediction data display device 330 also generates a data table containing the calculated level.

In step S1504, the prediction data display device 330 generates a display screen including the combined graph, the text table, and the data table, and displays the screen.

<Conclusion>

As is clear from the above description, the prediction data display system according to the second embodiment includes:

- comparing a width of the 95% confidence interval when the prediction data is predicted for the consumable to be predicted with a maximum width and a minimum width of the 95% confidence interval when the training process is performed with the training data, and calculating a level of the degree of normality of the width of the 95% confidence interval when the prediction data is predicted.

Thus, according to the second embodiment, the level of the degree of normality of the calculated prediction data can be quantified. As a result, the user can more easily determine whether the prediction data is correct or not.

That is, when a degree of deterioration of a consumable is predicted using a machine learning model, the present embodiment enables to more easily determine whether or not prediction data is correct.

[Third Embodiment]

In the second embodiment, the case where a combined graph, a text table, and a data table are displayed on the display screen has been described. In a third embodiment, data in a data table is displayed as a box plot on a display screen. The third embodiment will be described below, focusing on the differences from the second embodiment.

<Specific Example of Processing of Display Screen Generating Part of Prediction Data Display Device>

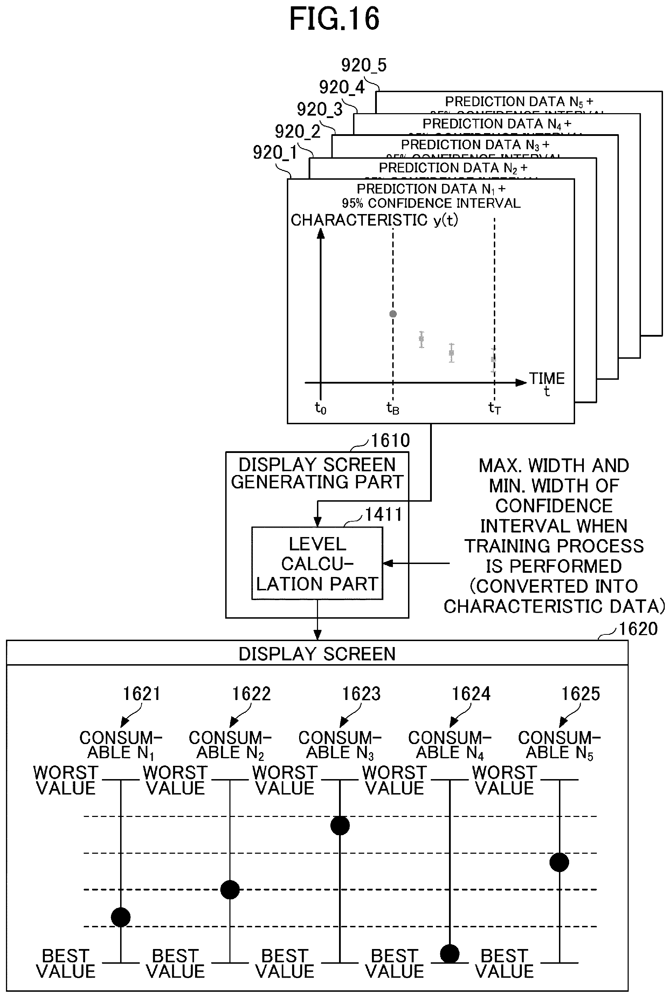

First, a specific example of the processing of a display screen generating part of the prediction data display device 330 will be described. FIG. 16 is a fourth diagram illustrating a specific example of the processing of the display screen generating part of the prediction data display device. As illustrated in FIG. 16, a display screen generating part 1610 includes the level calculation part 1411.

Note that the function of the level calculation part 1411 has been described in the second embodiment with reference to FIG. 14, and the description thereof will be omitted. In a case of the level calculation part 1411 illustrated in FIG. 16, there are a plurality of consumables to be predicted (five in the example of FIG. 16), and a plurality of 95% confidence intervals (converted into the characteristic data) is acquired from the second scale converter 333. Furthermore, in the case of the level calculation part 1411 illustrated in FIG. 16, a width (converted into the characteristic data) of the 95% confidence interval is calculated for each of the plurality of acquired 95% confidence intervals (converted into the characteristic data).

In the case of the level calculation part 1411 illustrated in FIG. 16, a level of the degree of normality is calculated by comparing each of the calculated widths (converted into the characteristic data) of the plurality of 95% confidence intervals with the worst value and the best value thereof.

Furthermore, in the case of the level calculation part 1411 illustrated in FIG. 16, box plots are generated based on each of the calculated levels, the worst values, and best values, and are displayed on a display screen 1620.

In the display screen 1620, a box plot 1621 represents a level calculated based on the width (converted into the characteristic data) of a 95% confidence interval when the prediction data for a consumable $N_1$ to be predicted is predicted.

Similarly, on the display screen 1620, box plots 1622 to 1625 represent levels calculated based on the widths (converted into the characteristic data) of 95% confidence intervals when the prediction data for a consumable $N_2$ to be predicted to a consumable $N_5$ to be predicted is predicted.

In such a way, when prediction data is predicted for a plurality of consumables to be predicted, by displaying box plots illustrating levels on one screen, the user can easily determine the correctness of the prediction data for the plurality of consumables.

<Conclusion>

As is clear from the above description, the prediction data display system according to the third embodiment includes:

- comparing widths of the 95% confidence intervals when prediction data is predicted for a plurality of consumables to be predicted with a maximum width and a minimum width of the 95% confidence interval when the training process is performed with the training data, and calculating levels of the degree of normality of the widths of the 95% confidence intervals when the plurality of prediction data is predicted; and
- arranging the calculated levels as box plots and displaying the plots on one screen.

Thus, according to the third embodiment, the user can visually recognize the calculated levels of the degrees of normality of the plurality of prediction data, and can easily determine whether the plurality of prediction data is correct.

That is, when degrees of deterioration of a plurality of consumables are predicted using a machine learning model, the present embodiment enables to more easily determine whether a plurality of prediction data is correct.

[Other Embodiments]

In the above embodiments, the training device and the prediction device are described as separate devices. However, the training device and the prediction device may be configured as an integrated device. Furthermore, in the above embodiments, the training data generating device and the training device are described as separate devices. However, the training data generating device and the training device may be configured as an integrated device. Similarly, in the above embodiments, the predictive data generating device and the prediction data display device are described as separate devices. However, the predictive data generating device and the prediction data display device may be configured as an integrated device.

In the above embodiments, the similarity calculation part is described as a part of the functions of the trained Gaussian process regression model, but may be implemented as a function part different from the trained Gaussian process regression model.

In the above embodiments, the discharge capacity retention rate of the battery is the characteristic data indicating the degree of deterioration of the consumable.

In the above embodiments, $r_X = y(t_X)/y(t_B)$ is calculated as an attenuation factor, but the method of calculating the attenuation factor is not limited thereto. For example, an attenuation factor obtained by converting $r_X$ by the following Equation 3 may be used.

[Math. 3]

$$\text{Attenuation factor after conversion} = \log\left(r_X \big/ (1 - r_X)\right)$$

(Equation 3)

In a case where the training process is performed on the Gaussian process regression model using the attenuation factor after the conversion as ground-truth data, the attenuation factor before the conversion can be calculated by the following Equation 4 for the attenuation factor after the conversion output from the trained Gaussian process regression model.

[Math. 4]

$$\text{Attenuation factor } r_X = 1 \big/ \left(1 + e^{-\eta}\right)$$

(Equation 4)

In such a case, the calculated attenuation factor is $0 < r_x < 1$.

In the above embodiments, a situation in which the prediction data for a consumable to be predicted is used is not mentioned. For example, the prediction data for the consumable to be predicted may be used for the manufacturing condition of the consumable to be predicted. Specifically, the consumable to be predicted is a battery (for example, a lithium ion secondary battery), and the conditions for activation, aging, and the like after completion of battery assembly may be determined based on the prediction data.

This application is based upon and claims priority to Japanese Patent Application No. 2021-150217 filed on September 15, 2021.

DESCRIPTION OF THE REFERENCE NUMERALS

100    prediction data display system
110    characteristic measuring device
120    training data generating device
121    training data
130    training device
131    Gaussian process regression model
300    prediction data display system
320    predictive data generating device
321    predictive data
330    prediction data display device
331    first scale converter
332    trained Gaussian process regression model
333    second scale converter
334    display screen generating part
601    attenuation factor calculation part
602    display appearance change part
701    similarity calculation part
702    confidence interval calculation part
703    attenuation factor prediction part
704    model parameter holding part
801    prediction data calculation part
802    confidence interval calculation part
1001    text data generating part
1002    graph combining part
1020    display screen
1021    text table
1022    combined graph
1110    display screen
1410    display screen generating part
1411    level calculation part

| | |
|---|---|
| 1420 | display screen |
| 1421 | data table |
| 1610 | display screen generating part |
| 1620 | display screen |

**Claims**

1. A prediction data display device (330) comprising:

a prediction part (332) configured to input, into a trained model on which a training process has been performed with training data in which information on first characteristic data is set as input data and information on second characteristic data is set as ground-truth data, information on third characteristic data to calculate information on fourth characteristic data, the first characteristic data indicating a degree of deterioration of a first consumable in a first period, the second characteristic data indicating a degree of deterioration of the first consumable in a second period after the first period, the third characteristic data indicating a degree of deterioration of a second consumable to be predicted in the first period, and the fourth characteristic data indicating a degree of deterioration of the second consumable to be predicted in the second period; and
a display part (334) configured to display a graph of the second characteristic data with a display appearance determined in accordance with a similarity between the information on the first characteristic data and the information on the third characteristic data, together with displaying a graph of the fourth characteristic data,
wherein the first and second consumables are batteries, and the information on the first and third characteristic data is a feature measured in a test in which charging and discharging of batteries are repeated,
wherein the first and third characteristic data is a discharge capacity retention rate in each cycle,
wherein the similarity is calculated according to the formula:

$$\mathrm{Similarity} = \exp\left(-\gamma\|\mathrm{F}_x - \mathrm{F}_y\|^2\right)$$

wherein $\gamma$ is a model parameter calculated when a training process is performed in a training phase of a model to obtain the trained model, $F_x$ is the information on the first characteristic data, and $F_y$ is the information on the third characteristic data,
wherein the display part (334) is configured to display the graph of the second characteristic data combined with a graph of the third characteristic data, and
wherein the display part (334) is configured to display the graph of the second characteristic data in a display color determined in accordance with the similarity.

2. The prediction data display device as claimed in claim 1, wherein the information on the second characteristic data is an attenuation factor of the second characteristic data in a case where characteristic data indicating a degree of deterioration of the first consumable at an end of the first period is used as a reference.

3. The prediction data display device as claimed in claim 2, wherein the display part is configured to display the graph of the second characteristic data generated by multiplying characteristic data indicating a degree of deterioration of the second consumable to be predicted at the end of the first period by the attenuation factor of the second characteristic data.

4. The prediction data display device as claimed in claim 1, wherein the information on the fourth characteristic data is an attenuation factor of the fourth characteristic data in a case where characteristic data indicating a degree of deterioration of the second consumable to be predicted at an end of the first period is used as a reference.

5. The prediction data display device as claimed in claim 4, wherein the display part is configured to display the graph of the fourth characteristic data generated by multiplying the characteristic data indicating the degree of deterioration of the second consumable to be predicted at the end of the first period by the attenuation factor of the fourth characteristic data.

6. The prediction data display device as claimed in claim 1, wherein the display part is configured to display information on a confidence interval calculated by the prediction part together with displaying the graph of the fourth characteristic data.

7. The prediction data display device as claimed in claim 1, wherein the display part is configured to display information indicating a type of the first consumable and information indicating a manufacturing condition of the first consumable, in association with the similarity, as a text table.

8. The prediction data display device as claimed in claim 1, wherein the display part is configured to calculate a level of normality of the fourth characteristic data by comparing a width of a confidence interval calculated by the prediction part with a minimum width and a maximum width of a confidence interval calculated by performing the training process on the model with the training data, and display the level.

9. The prediction data display device as claimed in claim 1, wherein the model is a Gaussian process regression model.

10. A method of displaying prediction data, the method comprising computer-implemented steps of:

inputting, into a trained model on which a training process has been performed with training data in which information on first characteristic data is set as input data and information on second characteristic data is set as ground-truth data, information on third characteristic data to calculate information on fourth characteristic data, the first characteristic data indicating a degree of deterioration of a first consumable in a first period, the second characteristic data indicating a degree of deterioration of the first consumable in a second period after the first period, the third characteristic data indicating a degree of deterioration of a second consumable to be predicted in the first period, and the fourth characteristic data indicating a degree of deterioration of the second consumable to be predicted in the second period; and
displaying a graph of the second characteristic data with a display appearance determined in accordance with a similarity between the information on the first characteristic data and the information on the third characteristic data, together with displaying a graph of the fourth characteristic data,
wherein the first and second consumables are batteries, and the information on the first and third characteristic data is a feature measured in a test in which charging and discharging of batteries are repeated,
wherein the first and third characteristic data is a discharge capacity retention rate in each cycle,
wherein the similarity is calculated according to the formula:

$$\text{Similarity} = \exp\left(-\gamma \|F_x - F_y\|^2\right)$$

wherein $\gamma$ is a model parameter calculated when a training process is performed in a training phase of a model to obtain the trained model, $F_x$ is the information on the first characteristic data, and $F_y$ is the information on the third characteristic data,
wherein the step of displaying a graph of the second characteristic data is displaying the graph of the second characteristic data combined with a graph of the third characteristic data, and
wherein the step of displaying a graph of the second characteristic data is displaying the graph of the second characteristic data in a display color determined in accordance with the similarity.

11. A program of displaying prediction data, the program causing a computer to execute steps of:

inputting, into a trained model on which a training process has been performed with training data in which information on first characteristic data is set as input data and information on second characteristic data is set as ground-truth data, information on third characteristic data to calculate information on fourth characteristic data, the first characteristic data indicating a degree of deterioration of a first consumable in a first period, the second characteristic data indicating a degree of deterioration of the first consumable in a second period after the first period, the third characteristic data indicating a degree of deterioration of a second consumable to be predicted in the first period, and the fourth characteristic data indicating a degree of deterioration of the second consumable to be predicted in the second period; and
displaying a graph of the second characteristic data with a display appearance determined in accordance with a similarity between the information on the first characteristic data and the information on the third characteristic data, together with displaying a graph of the fourth characteristic data,
wherein the first and second consumables are batteries, and the information on the first and third characteristic data is a feature measured in a test in which charging and discharging of batteries are repeated,
wherein the first and third characteristic data is a discharge capacity retention rate in each cycle,
wherein the similarity is calculated according to the formula:

$$\text{Similarity} = exp\ (-\gamma\|F_x - F_y\|^2)$$

wherein $\gamma$ is a model parameter calculated when a training process is performed in a training phase of a model to obtain the trained model, $F_x$ is the information on the first characteristic data, and $F_y$ is the information on the third characteristic data,

wherein the step of displaying a graph of the second characteristic data is displaying the graph of the second characteristic data combined with a graph of the third characteristic data, and

wherein the step of displaying a graph of the second characteristic data is displaying the graph of the second characteristic data in a display color determined in accordance with the similarity.

**Patentansprüche**

1. Vorhersagedaten-Anzeigevorrichtung (330), umfassend:

ein Vorhersageteil (332), das konfiguriert ist, um in ein trainiertes Modell, an dem ein Trainingsprozess mit Trainingsdaten durchgeführt wurde, in denen Informationen über erste charakteristische Daten als Eingabedaten festgelegt sind und Informationen über zweite charakteristische Daten als Ground-Truth-Daten festgelegt sind, Informationen über dritte charakteristische Daten einzugeben, um Informationen über vierte charakteristische Daten zu berechnen, wobei die ersten charakteristischen Daten einen Grad der Verschlechterung eines ersten Verbrauchsmaterials in einer ersten Periode anzeigen, die zweiten charakteristischen Daten einen Grad der Verschlechterung des ersten Verbrauchsmaterials in einer zweiten Periode nach der ersten Periode anzeigen, die dritten charakteristischen Daten einen Grad der Verschlechterung eines zweiten vorherzusagenden Verbrauchsmaterials in der ersten Periode anzeigen und die vierten charakteristischen Daten einen Grad der Verschlechterung des zweiten vorherzusagenden Verbrauchsmaterials in der zweiten Periode anzeigen; und

ein Anzeigeteil (334), das konfiguriert ist, um einen Graphen der zweiten charakteristischen Daten mit einem Anzeigeerscheinungsbild, das in Übereinstimmung mit einer Ähnlichkeit zwischen den Informationen über die ersten charakteristischen Daten und den Informationen über die dritten charakteristischen Daten bestimmt wird, zusammen mit dem Anzeigen eines Graphen der vierten charakteristischen Daten anzuzeigen,

wobei das erste und das zweite Verbrauchsmaterial Batterien sind und die Informationen über die ersten und dritten charakteristischen Daten ein Merkmal sind, das in einem Test gemessen wird, in dem Laden und Entladen von Batterien wiederholt werden,

wobei die ersten und dritten charakteristischen Daten eine Entladekapazitätserhaltungsrate in jedem Zyklus sind,

wobei die Ähnlichkeit gemäß der Formel berechnet wird:

$$\text{Ähnlichkeit} = exp\ (-\gamma\|F_x - F_y\|^2),$$

wobei $\gamma$ ein Modellparameter ist, der berechnet wird, wenn ein Trainingsprozess in einer Trainingsphase eines Modells durchgeführt wird, um das trainierte Modell zu erhalten, $F_x$ die Informationen über die ersten charakteristischen Daten sind und $F_y$ die Informationen über die dritten charakteristischen Daten sind,

wobei das Anzeigeteil (334) konfiguriert ist, um den Graphen der zweiten charakteristischen Daten kombiniert mit einem Graphen der dritten charakteristischen Daten anzuzeigen, und

wobei das Anzeigeteil (334) konfiguriert ist, um den Graphen der zweiten charakteristischen Daten in einer Anzeigefarbe anzuzeigen, die in Übereinstimmung mit der Ähnlichkeit bestimmt wird.

2. Vorhersagedaten-Anzeigevorrichtung nach Anspruch 1, wobei die Informationen über die zweiten charakteristischen Daten ein Abschwächungsfaktor der zweiten charakteristischen Daten in einem Fall sind, in dem charakteristische Daten, die einen Grad der Verschlechterung des ersten Verbrauchsmaterials am Ende der ersten Periode anzeigen, als Referenz verwendet werden.

3. Vorhersagedaten-Anzeigevorrichtung nach Anspruch 2, wobei das Anzeigeteil konfiguriert ist, um den Graphen der zweiten charakteristischen Daten anzuzeigen, der durch Multiplizieren von charakteristischen Daten, die einen Grad der Verschlechterung des zweiten vorherzusagenden Verbrauchsmaterials am Ende der ersten Periode anzeigen, mit dem Abschwächungsfaktor der zweiten charakteristischen Daten erzeugt wird.

4. Vorhersagedaten-Anzeigevorrichtung nach Anspruch 1, wobei die Informationen über die vierten charakteristischen Daten ein Abschwächungsfaktor der vierten charakteristischen Daten in einem Fall sind, in dem charakteristische Daten, die einen Grad der Verschlechterung des zweiten vorherzusagenden Verbrauchsmaterials am Ende der ersten Periode anzeigen, als Referenz verwendet werden.

5. Vorhersagedaten-Anzeigevorrichtung nach Anspruch 4, wobei das Anzeigeteil konfiguriert ist, um den Graphen der vierten charakteristischen Daten anzuzeigen, der durch Multiplizieren der charakteristischen Daten, die den Grad der Verschlechterung des zweiten vorherzusagenden Verbrauchsmaterials am Ende der ersten Periode anzeigen, mit dem Abschwächungsfaktor der vierten charakteristischen Daten erzeugt wird.

6. Vorhersagedaten-Anzeigevorrichtung nach Anspruch 1, wobei das Anzeigeteil konfiguriert ist, um Informationen über ein Konfidenzintervall, das durch das Vorhersageteil berechnet wird, zusammen mit dem Anzeigen des Graphen der vierten charakteristischen Daten anzuzeigen.

7. Vorhersagedaten-Anzeigevorrichtung nach Anspruch 1, wobei das Anzeigeteil konfiguriert ist, um Informationen, die einen Typ des ersten Verbrauchsmaterials anzeigen, und Informationen, die eine Herstellungsbedingung des ersten Verbrauchsmaterials anzeigen, in Zuordnung zu der Ähnlichkeit als Texttabelle anzuzeigen.

8. Vorhersagedaten-Anzeigevorrichtung nach Anspruch 1, wobei das Anzeigeteil konfiguriert ist, um einen Grad der Normalität der vierten charakteristischen Daten zu berechnen, indem eine Breite eines Konfidenzintervalls, das durch das Vorhersageteil berechnet wird, mit einer minimalen Breite und einer maximalen Breite eines Konfidenzintervalls verglichen wird, das durch Durchführen des Trainingsprozesses an dem Modell mit den Trainingsdaten berechnet wird, und den Grad anzuzeigen.

9. Vorhersagedaten-Anzeigevorrichtung nach Anspruch 1, wobei das Modell ein Gaußsches Prozessregressionsmodell ist.

10. Verfahren zum Anzeigen von Vorhersagedaten, wobei das Verfahren computerimplementierte die folgenden Schritte umfasst:

Eingeben von Informationen über dritte charakteristische Daten in ein trainiertes Modell, an dem ein Trainingsprozess mit Trainingsdaten durchgeführt wurde, in denen Informationen über erste charakteristische Daten als Eingabedaten festgelegt sind und Informationen über zweite charakteristische Daten als Ground-Truth-Daten festgelegt sind, um Informationen über vierte charakteristische Daten zu berechnen, wobei die ersten charakteristischen Daten einen Grad der Verschlechterung eines ersten Verbrauchsmaterials in einer ersten Periode anzeigen, die zweiten charakteristischen Daten einen Grad der Verschlechterung des ersten Verbrauchsmaterials in einer zweiten Periode nach der ersten Periode anzeigen, die dritten charakteristischen Daten einen Grad der Verschlechterung eines zweiten vorherzusagenden Verbrauchsmaterials in der ersten Periode anzeigen und die vierten charakteristischen Daten einen Grad der Verschlechterung des zweiten vorherzusagenden Verbrauchsmaterials in der zweiten Periode anzeigen; und
Anzeigen eines Graphen der zweiten charakteristischen Daten mit einem Anzeigeerscheinungsbild, das in Übereinstimmung mit einer Ähnlichkeit zwischen den Informationen über die ersten charakteristischen Daten und den Informationen über die dritten charakteristischen Daten bestimmt wird, zusammen mit dem Anzeigen eines Graphen der vierten charakteristischen Daten,
wobei das erste und das zweite Verbrauchsmaterial Batterien sind und die Informationen über die ersten und dritten charakteristischen Daten ein Merkmal sind, das in einem Test gemessen wird, in dem Laden und Entladen von Batterien wiederholt werden,
wobei die ersten und dritten charakteristischen Daten eine Entladekapazitätserhaltungsrate in jedem Zyklus sind,
wobei die Ähnlichkeit gemäß der Formel berechnet wird:

$$\text{Ähnlichkeit} = exp\left(-\gamma \|F_x - F_y\|^2\right)$$

wobei $\gamma$ ein Modellparameter ist, der berechnet wird, wenn ein Trainingsprozess in einer Trainingsphase eines Modells durchgeführt wird, um das trainierte Modell zu erhalten, $F_x$ die Informationen über die ersten charakteristischen Daten sind und $F_y$ die Informationen über die dritten charakteristischen Daten sind,
wobei der Schritt des Anzeigens eines Graphen der zweiten charakteristischen Daten das Anzeigen des Graphen der zweiten charakteristischen Daten kombiniert mit einem Graphen der dritten charakteristischen Daten ist, und

wobei der Schritt des Anzeigens eines Graphen der zweiten charakteristischen Daten das Anzeigen des Graphen der zweiten charakteristischen Daten in einer Anzeigefarbe ist, die in Übereinstimmung mit der Ähnlichkeit bestimmt wird.

11. Programm zum Anzeigen von Vorhersagedaten, wobei das Programm einen Computer veranlasst, die folgende Schritte auszuführen:

Eingeben von Informationen über dritte charakteristische Daten in ein trainiertes Modell, an dem ein Trainingsprozess mit Trainingsdaten durchgeführt wurde, in denen Informationen über erste charakteristische Daten als Eingabedaten festgelegt sind und Informationen über zweite charakteristische Daten als Ground-Truth-Daten festgelegt sind, um Informationen über vierte charakteristische Daten zu berechnen, wobei die ersten charakteristischen Daten einen Grad der Verschlechterung eines ersten Verbrauchsmaterials in einer ersten Periode anzeigen, die zweiten charakteristischen Daten einen Grad der Verschlechterung des ersten Verbrauchsmaterials in einer zweiten Periode nach der ersten Periode anzeigen, die dritten charakteristischen Daten einen Grad der Verschlechterung eines zweiten vorherzusagenden Verbrauchsmaterials in der ersten Periode anzeigen und die vierten charakteristischen Daten einen Grad der Verschlechterung des zweiten vorherzusagenden Verbrauchsmaterials in der zweiten Periode anzeigen; und

Anzeigen eines Graphen der zweiten charakteristischen Daten mit einem Anzeigeerscheinungsbild, das in Übereinstimmung mit einer Ähnlichkeit zwischen den Informationen über die ersten charakteristischen Daten und den Informationen über die dritten charakteristischen Daten bestimmt wird, zusammen mit dem Anzeigen eines Graphen der vierten charakteristischen Daten,

wobei das erste und das zweite Verbrauchsmaterial Batterien sind und die Informationen über die ersten und dritten charakteristischen Daten ein Merkmal sind, das in einem Test gemessen wird, in dem Laden und Entladen von Batterien wiederholt werden,

wobei die ersten und dritten charakteristischen Daten eine Entladekapazitätserhaltungsrate in jedem Zyklus sind,

wobei die Ähnlichkeit gemäß der Formel berechnet wird:

$$\text{Ähnlichkeit} = e \times p(-\gamma \|F_x - F_y\|^2),$$

wobei $\gamma$ ein Modellparameter ist, der berechnet wird, wenn ein Trainingsprozess in einer Trainingsphase eines Modells durchgeführt wird, um das trainierte Modell zu erhalten, $F_x$ die Informationen über die ersten charakteristischen Daten sind und $F_y$ die Informationen über die dritten charakteristischen Daten sind,

wobei der Schritt des Anzeigens eines Graphen der zweiten charakteristischen Daten das Anzeigen des Graphen der zweiten charakteristischen Daten kombiniert mit einem Graphen der dritten charakteristischen Daten ist, und

wobei der Schritt des Anzeigens eines Graphen der zweiten charakteristischen Daten das Anzeigen des Graphen der zweiten charakteristischen Daten in einer Anzeigefarbe ist, die in Übereinstimmung mit der Ähnlichkeit bestimmt wird.

## Revendications

1. Dispositif (330) d'affichage de données de prédiction comprenant :

une partie de prédiction (332) configurée pour entrer, dans un modèle entraîné sur lequel un processus d'apprentissage a été effectué avec des données d'entraînement dans lesquelles les informations relatives aux premières données caractéristiques sont définies comme données d'entrée et les informations relatives aux deuxièmes données caractéristiques sont définies comme données de référence, les informations relatives aux troisièmes données caractéristiques servant à calculer les informations relatives aux quatrièmes données caractéristiques, les premières données caractéristiques indiquant un degré de détérioration d'un premier consommable au cours d'une première période, les deuxièmes données caractéristiques indiquant un degré de détérioration du premier consommable au cours d'une deuxième période après la première période, les troisièmes données caractéristiques indiquant un degré de détérioration d'un deuxième consommable à prédire au cours de la première période, et les quatrièmes données caractéristiques indiquant un degré de détérioration du deuxième consommable à prédire au cours de la deuxième période ; et

une partie d'affichage (334) configurée pour afficher un graphique des deuxièmes données caractéristiques avec une apparence d'affichage déterminée en fonction d'une similarité entre les informations relatives aux premières données caractéristiques et les informations relatives aux troisièmes données caractéristiques, ainsi que pour afficher un graphique des quatrièmes données caractéristiques,

dans lequel les premier et deuxième consommables sont des batteries, et les informations relatives aux première et troisième données caractéristiques correspondent à une caractéristique mesurée lors d'un test au cours duquel la charge et la décharge des batteries sont répétées,

dans lequel les première et troisième données caractéristiques sont un taux de rétention de la capacité de décharge dans chaque cycle,

dans lequel la similarité est calculée selon la formule suivante :

$$\text{Similarité} = exp\left(-\gamma \|F_x - F_y\|^2\right)$$

dans laquelle $\gamma$ est un paramètre du modèle calculé lors d'un processus d'apprentissage effectué au cours d'une phase d'apprentissage d'un modèle afin d'obtenir le modèle entraîné, $F_x$ désigne les informations relatives aux premières données caractéristiques, et $F_Y$ désigne les informations relatives aux troisièmes données caractéristiques,

dans lequel la partie d'affichage (334) est configurée pour afficher le graphique des deuxièmes données caractéristiques combiné à un graphique des troisièmes données caractéristiques, et

dans lequel la partie d'affichage (334) est configurée pour afficher le graphique des deuxièmes données caractéristiques dans une couleur d'affichage déterminée en fonction de la similarité.

2. Dispositif d'affichage de données de prédiction selon la revendication 1, dans lequel les informations relatives aux deuxièmes données caractéristiques correspondent à un facteur d'atténuation de ces deuxièmes données caractéristiques, dans le cas où les données caractéristiques indiquant le degré de détérioration du premier consommable à la fin de la première période sont utilisées comme référence.

3. Dispositif d'affichage de données de prédiction selon la revendication 2, dans lequel la partie d'affichage est configurée pour afficher le graphique des deuxièmes données caractéristiques générées en multipliant les données caractéristiques indiquant le degré de détérioration du deuxième consommable à prédire à la fin de la première période par le facteur d'atténuation des deuxièmes données caractéristiques.

4. Dispositif d'affichage de données de prédiction selon la revendication 1, dans lequel les informations relatives aux quatrièmes données caractéristiques correspondent à un facteur d'atténuation des quatrièmes données caractéristiques, dans le cas où les données caractéristiques indiquant le degré de détérioration du deuxième consommable à prédire à la fin de la première période sont utilisées comme référence.

5. Dispositif d'affichage de données de prédiction selon la revendication 4, dans lequel la partie d'affichage est configurée pour afficher le graphique des quatrièmes données caractéristiques générées en multipliant les données caractéristiques indiquant le degré de détérioration du deuxième consommable à prédire à la fin de la première période par le facteur d'atténuation des quatrièmes données caractéristiques.

6. Dispositif d'affichage de données de prédiction selon la revendication 1, dans lequel la partie d'affichage est configurée pour afficher des informations relatives à un intervalle de confiance calculé par la partie de prédiction, avec l'affichage du graphique des quatrième données caractéristiques.

7. Dispositif d'affichage de données de prédiction selon la revendication 1, dans lequel la partie d'affichage est configurée pour afficher, sous forme de tableau textuel, des informations indiquant le type du premier consommable et des informations indiquant l'état de fabrication du premier consommable, en association avec le degré de similarité.

8. Dispositif d'affichage de données de prédiction selon la revendication 1, dans lequel la partie d'affichage est configurée pour calculer un niveau de normalité des quatrièmes données caractéristiques en comparant la largeur d'un intervalle de confiance calculé par la partie de prédiction avec la largeur minimale et la largeur maximale d'un intervalle de confiance calculé en effectuant le processus d'apprentissage sur le modèle à l'aide des données d'entraînement, et pour afficher ce niveau.

9. Dispositif d'affichage de données de prédiction selon la revendication 1, dans lequel le modèle est un modèle de régression par processus Gaussien.

10. Procédé d'affichage de données de prédiction, le procédé comprenant les étapes mises en œuvre par ordinateur suivantes :

entrer, dans un modèle entraîné sur lequel un processus d'apprentissage a été effectué relatives aux premières données caractéristiques sont définies comme données d'entrée et des informations relatives aux deuxièmes données caractéristiques sont définies comme données de référence, des informations relatives aux troisièmes données caractéristiques servant à calculer les informations relatives aux quatrièmes données caractéristiques, les premières données caractéristiques indiquant un degré de détérioration d'un premier consommable au cours d'une première période, les deuxièmes données caractéristiques indiquant un degré de détérioration du premier consommable au cours d'une deuxième période suivant la première période, les troisièmes données caractéristiques indiquant un degré de détérioration d'un deuxième consommable à prédire au cours de la première période, et les quatrièmes données caractéristiques indiquant un degré de détérioration du deuxième consommable à prédire au cours de la deuxième période ; et

afficher un graphique des deuxièmes données caractéristiques avec une apparence d'affichage déterminée en fonction d'une similarité entre les informations relatives aux premières données caractéristiques et les informations relatives aux troisièmes données caractéristiques, ainsi que l'affichage d'un graphique représentant les quatrièmes données caractéristiques,

dans lequel les premier et deuxième consommables sont des batteries, et les informations relatives aux premières et troisièmes données caractéristiques correspondent à une caractéristique mesurée lors d'un test au cours duquel la charge et la décharge des batteries sont répétées,

dans lequel les premières et troisièmes données caractéristiques correspondent au taux de rétention de la capacité de décharge dans chaque cycle,

dans lequel la similarité est calculée selon la formule suivante :

$$\text{Similarité} = \exp\left(-\gamma\|F_x - F_y\|^2\right)$$

dans laquelle $\gamma$ est un paramètre du modèle calculé lors d'un processus d'apprentissage effectué au cours d'une phase d'apprentissage d'un modèle afin d'obtenir le modèle entraîné, $F_X$ désigne les informations relatives aux premières données caractéristiques, et $F_Y$, désigne les informations relatives aux troisièmes données caractéristiques,

dans lequel l'étape consistant à afficher un graphique des deuxièmes données caractéristiques consiste à afficher le graphique des deuxièmes données caractéristiques combiné à un graphique des troisièmes données caractéristiques, et

dans lequel l'étape consistant à afficher un graphique des deuxièmes données caractéristiques consiste à afficher le graphique des deuxièmes données caractéristiques dans une couleur d'affichage déterminée en fonction de la similarité.

11. Programme destiné à afficher des données de prédiction, le programme amenant un ordinateur à exécuter les étapes suivantes :

entrer, dans un modèle entraîné sur lequel un processus d'apprentissage a été effectué à l'aide de données d'entraînement dans lesquelles des informations relatives aux premières données caractéristiques sont définies comme les données d'entrée et les informations relatives aux deuxièmes données caractéristiques sont définies comme données de référence, les informations relatives aux troisièmes données caractéristiques servant à calculer les informations relatives aux quatrièmes données caractéristiques, les premières données caractéristiques indiquant un degré de détérioration d'un premier consommable au cours d'une première période, les deuxièmes données caractéristiques indiquant un degré de détérioration du premier consommable au cours d'une deuxième période suivant la première période, les troisièmes données caractéristiques indiquant un degré de détérioration d'un deuxième consommable à prédire au cours de la première période, et les quatrièmes données caractéristiques indiquant un degré de détérioration du deuxième consommable à prédire au cours de la deuxième période ; et

afficher un graphique des deuxièmes données caractéristiques avec une apparence d'affichage déterminée en fonction d'une similarité entre les informations relatives aux premières données caractéristiques et les informations relatives aux troisièmes données caractéristiques, ainsi que l'affichage d'un graphique des quatrièmes données caractéristiques,

dans lequel les premier et deuxième consommables sont des batteries, et les informations relatives aux premières et troisièmes données caractéristiques sont une caractéristique mesurée lors d'un test dans lequel la charge et la décharge des batteries sont répétées,

dans lequel les premières et troisièmes données caractéristiques sont un taux de rétention de la capacité de décharge dans chaque cycle,

dans lequel la similarité est calculée selon la formule :

$$\text{Similarité} = \exp\left(-\gamma \| F_x - F_y \|^2\right)$$

dans laquelle $\gamma$ est un paramètre de modèle calculé lors de l'exécution d'un processus d'apprentissage dans une phase d'apprentissage d'un modèle afin d'obtenir le modèle entraîné, $F_X$ désigne les informations relatives aux premières données caractéristiques, et $F_Y$ désigne les informations relatives aux troisièmes données caractéristiques,

dans lequel l'étape consistant à afficher un graphique des deuxièmes données caractéristiques consiste à afficher le graphique des deuxièmes données caractéristiques combiné à un graphique des troisièmes données caractéristiques, et

dans lequel l'étape consistant à afficher un graphique des deuxièmes données caractéristiques consiste à afficher le graphique des deuxièmes données caractéristiques dans une couleur d'affichage déterminée en fonction de la similarité.

# FIG.1

100

CONSUMABLE
I

CONSUMABLE

CONSUMABLE

→

CHARACTERISTIC
MEASURING
DEVICE

110

→

CHARACTER-
ISTIC DATA
I

CHARACTER-

CHARACTER-

MANUFACTURING
CONDITION i, ii, iii, • • •

FEATURE
I, II, III, • • •

TRAINING DATA
GENERATING
DEVICE

120

121

| TRAINING DATA | | | |
|---|---|---|---|
| ID | REFER-ENCE DATA | INPUT DATA | GROUND-TRUTH DATA |
| CON-SUM-ABLE TYPE | MANU-FAC-TURING CONDI-TION | FEATURE MEASURED FROM MEASUREMENT START TIME TO REFERENCE TIME | ATTENUATION FACTOR OF CHARACTERISTIC DATA AFTER REFERENCE TIME WITH REFERENCE TO CHARACTERISTIC DATA AT REFERENCE TIME |

130

TRAINING DEVICE

133

TRAINING DATA
STORAGE PART

→

131

GAUSSIAN
PROCESS
REGRESSION
MODEL

→

132

COMPARISON/
CHANGE PART

# FIG.2

FEATURE 1($t_X$),
FEATURE 2($t_X$),
FEATURE 3($t_X$),

| | | TRAINING DATA | |
|---|---|---|---|
| ID | REFER-ENCE DATA | INPUT DATA ($t_0 \leqq t_X \leqq t_B$) | GROUND-TRUTH DATA ($t_B \leqq t_X \leqq t_T$) |
| I | MANUFAC-TURING CONDITION i | FEATURE 1($t_X$)_I, FEATURE 2($t_X$)_I, $\cdots$ FEATURE n($t_X$)_I | ATTENUATION FACTOR $r(t_X)\_I = y(t_X)\_I / y(t_B)\_I$ |
| II | MANUFAC-TURING CONDITION ii | FEATURE 1($t_X$)_II, FEATURE 2($t_X$)_II, $\cdots$ FEATURE n($t_X$)_II | ATTENUATION FACTOR $r(t_X)\_II = y(t_X)\_II / y(t_B)\_II$ |
| III | MANUFAC-TURING CONDITION iii | FEATURE 1($t_X$)_III, FEATURE 2($t_X$)_III, $\cdots$ FEATURE n($t_X$)_III | ATTENUATION FACTOR $r(t_X)\_III = y(t_X)\_III / y(t_B)\_III$ |

# FIG.3

<u>300</u>

```
┌──────────────┐      ┌──────────────┐      ┌──────────────┐
│              │      │CHARACTERISTIC│  110 │ CHARACTER-   │
│ CONSUMABLE   │─────▶│  MEASURING   │      │ ISTIC DATA   │
│      N       │      │   DEVICE     │─────▶│      N       │
└──────────────┘      └──────────────┘      └──────────────┘
```

MANUFACTURING CONDITION m     FEATURE N

```
                    ┌──────────────┐
                    │  PREDICTIVE  │  320
                    │     DATA     │
                    │  GENERATING  │
                    │    DEVICE    │
                    └──────────────┘
```

### PREDICTIVE DATA    321

| ID | REFER-ENCE DATA | DATA FOR SCALE CONVERSION | INPUT DATA | DISPLAY DATA |
|---|---|---|---|---|
| CON-SUM-ABLE TYPE | MANU-FAC-TURING CONDI-TION | CHARAC-TERISTIC DATA AT REFER-ENCE TIME | FEATURE MEASURED FROM MEASUREMENT START TIME TO REFERENCE TIME | CHARACTERISTIC DATA FROM MEASUREMENT START TIME TO REFERENCE TIME |

### PREDICTION DATA DISPLAY DEVICE    330

```
┌──────────────┐      SIMILARITY        ┌──────────────┐
│ FIRST SCALE  │◀──────────────────────│  TRAINED     │  332
│  CONVERTER   │  331                   │  GAUSSIAN    │
│              │                        │  PROCESS     │
└──────────────┘       ATTENUATION      │  REGRESSION  │
                        FACTOR          │   MODEL      │
                                        └──────────────┘
```

ATTENUATION FACTOR    FEATURE

- PREDICTED ATTENUATION FACTOR AFTER REFERENCE TIME
- 95% CONFIDENCE INTERVAL

133 — TRAINING DATA STORAGE PART

```
                                        ┌──────────────┐
                                        │ SECOND       │  333
                                        │ SCALE        │
                                        │ CONVERTER    │
                                        └──────────────┘
```

ID, REFERENCE DATA

- CHARACTERISTIC DATA AFTER REFERENCE TIME
- SIMILARITY

```
      ┌──────────────────┐
      │  DISPLAY SCREEN   │  334
      │ GENERATING PART   │
      └──────────────────┘
```

- PREDICTION DATA AFTER REFERENCE TIME
- 95% CONFIDENCE INTERVAL (CONVERTED INTO CHARACTERISTIC DATA)

# FIG.4

CHARACTERISTIC DATA N
CHARACTERISTIC
$y(t)$

$y(t_0)\_N$

$y(t_B)\_N$

TIME $t$

$t_0$    $t_B$    $t_T$

410

FEATURE $1(t_X)$,
FEATURE $2(t_X)$,
FEATURE $3(t_X)$,
:
:
:

PREDICTIVE DATA
GENERATING
DEVICE

320

321'

| | | | | |
|---|---|---|---|---|
| PREDICTIVE DATA | | | | |
| ID | REFER-ENCE DATA | DATA FOR SCALE CONVER-SION | INPUT DATA $(t_0 \leqq t_X \leqq t_B)$ | DISPLAY DATA $(t_0 \leqq t_X \leqq t_B)$ |
| N | MANU-FAC-TURING CONDI-TION $\varepsilon$ | CHARAC-TERISTIC DATA $y(t_B)\_N$ | FEATURE $1(t_X)\_N$, FEATURE $2(t_X)\_N$, $\cdots$ FEATURE $n(t_X)\_N$ | CHARACTERISTIC DATA $y(t_X)\_N$ |

# FIG.5

**TRAINING DEVICE AND PREDICTION DATA DISPLAY DEVICE** ~130, 330

~501 **PROCESSOR**

~502 **MEMORY**

~503 **AUXILIARY STORAGE DEVICE**

~507

~504 **I/F DEVICE**

~505 **COMMUNICATION DEVICE**

~506 **DRIVE DEVICE**

~510 **DISPLAY DEVICE**

~520 **OPERATION DEVICE**

~120 **TRAINING DATA GENERATING DEVICE**

~530 **RECORDING MEDIUM**

OR

~320 **PREDICTIVE DATA GENERATING DEVICE**

EP 4 404 113 B1

# FIG.6

CHARACTERISTIC DATA N

CHARACTERISTIC
$y(t)$

410

$y(t_0)\_N$

$y(t_B)\_N$

TIME
$t$

$t_0$    $t_B$    $t_T$

CHARACTERISTIC DATA
$y(t_B)\_N$

CHARACTERISTIC DATA
AT REFERENCE TIME

SIMILARITY I,
SIMILARITY II,
SIMILARITY III,

331

FIRST SCALE CONVERTER

CHARACTERISTIC
DATA AFTER
REFERENCE
TIME

601

ATTENUATION
FACTOR CALCU-
LATION PART

ATTENUATION
FACTOR $\times y(t_B)\_N$

602

DISPLAY
APPEARANCE
CHANGE PART

SIMILARITY=1→BLUE
SIMILARITY=0→GRAY

SIMI-
LARITY

ATTEN-
UATION
FACTOR

CHARACTERISTIC DATA
$y(t_X)\_I/y(t_B)\_I \times y(t_B)\_N$ (WHERE, $t_B \leqq t_X \leqq t_T$)
CHARACTERISTIC DATA
$y(t_X)\_II/y(t_B)\_II \times y(t_B)\_N$ (WHERE, $t_B \leqq t_X \leqq t_T$)
CHARACTERISTIC DATA
$y(t_X)\_III/y(t_B)\_III \times y(t_B)\_N$ (WHERE, $t_B \leqq t_X \leqq t_T$)

ATTENUATION FACTOR
$r(t_X)\_I=y(t_X)\_I/y(t_B)\_I$
ATTENUATION FACTOR
$r(t_X)\_II=y(t_X)\_II/y(t_B)\_II$
ATTENUATION FACTOR
$r(t_X)\_III=y(t_X)\_III/y(t_B)\_III$

**FIG.7**

FEATURE $F_x$(FEATURE $1(t_X)$_N, FEATURE $2(t_X)$_N, $\cdots$FEATURE $n(t_X)$_N)

TRAINED GAUSSIAN PROCESS REGRESSION MODEL

332

701

SIMILARITY CALCULATION PART

$\exp(-\gamma\|F_x-F_y\|^2)$

SIMILARITY I,
SIMILARITY II,
SIMILARITY III,

702

CONFIDENCE INTERVAL CALCULATION PART

703

ATTENUATION FACTOR PREDICTION PART

704

MODEL PARAMETER HOLDING PART
$C_{var}, \gamma, C_{bias}, \alpha$

FEATURE $F_y$(FEATURE $1(t_X)$_I,
FEATURE $2(t_X)$_I, $\cdots$FEATURE $n(t_X)$_I)
FEATURE $F_y$(FEATURE $1(t_X)$_II,
FEATURE $2(t_X)$_II, $\cdots$FEATURE $n(t_X)$_II)
FEATURE $F_y$(FEATURE $1(t_X)$_III,
FEATURE $2(t_X)$_III, $\cdots$FEATURE $n(t_X)$_III)

PREDICTED ATTENUATION FACTOR r'$(t_X)$_N

95% CONFIDENCE INTERVAL
(Max_r' $(t_X)$_N, Min_r' $(t_X)$_N)

# FIG.8

CHARACTERISTIC DATA N ⌒410

CHARACTERISTIC
y(t)

y($t_0$)_N

y($t_B$)_N

TIME
t

$t_0$     $t_B$     $t_T$

CHARACTERISTIC DATA
AT REFERENCE TIME

CHARACTERISTIC
DATA y($t_B$)_N

PREDICTED ATTENUATION
FACTOR r'($t_X$)_N

95% CONFIDENCE INTERVAL
(Max_r'($t_X$)_N, Min_r'($t_X$)_N)

⌒333

SECOND SCALE
CONVERTER

⌒801

PREDICTION DATA
CALCULATION PART

PREDICTED
ATTENUATION
FACTOR ×y($t_B$)_N

⌒802

CONFIDENCE INTERVAL
CALCULATION PART

95% CONFIDENCE
INTERVAL ×y($t_B$)_N

PREDICTION DATA
y'($t_X$)_N

95% CONFIDENCE INTERVAL
(Max_r'($t_X$)_N × y($t_B$)_N, Min_r'($t_X$)_N × y($t_B$)_N)

# FIG.9

PREDICTION DATA N
CHARACTERISTIC y(t)

$y(t_0)\_N$

$y(t_B)\_N$

TIME
t

$t_0$    $t_B$    $t_T$

910

PREDICTION DATA N + 95% CONFIDENCE INTERVAL
CHARACTERISTIC y(t)

$y(t_0)\_N$

$y(t_B)\_N$

TIME
t

$t_0$    $t_B$    $t_T$

920

PREDICTION DATA N + 95% CONFIDENCE INTERVAL
CHARACTERISTIC y(t)

$y(t_0)\_N$

$y(t_B)\_N$

95%
CONFIDENCE
INTERVAL

TIME
t

$t_0$    $t_B$    $t_T$

930

# FIG.10

1010_3
1010_2
1010_1

CHARACTERISTIC DATA

**CHARACTERISTIC DATA AFTER REFERENCE TIME I**
CHARACTERISTIC y(t)

$y(t_B)\_N$

TIME t

$t_0$    $t_B$    $t_T$

920

**PREDICTION DATA N + 95% CONFIDENCE INTERVAL**
CHARACTERISTIC y(t)

$y(t_B)\_N$

TIME t

$t_0$    $t_B$    $t_T$

ID REFERENCE DATA    SIMI-LARITY

334

**DISPLAY SCREEN GENERATING PART**

1001

**TEXT DATA GENERATING PART**

1002

**GRAPH COMBINING PART**

DISPLAY DATA

1020

**DISPLAY SCREEN**

1021

| CONSUM-ABLE I | SIMILAR-ITY I | MANU-FACTURING CONDITION i |
|---|---|---|
| CONSUM-ABLE II | SIMILAR-ITY II | MANU-FACTURING CONDITION ii |
| CONSUM-ABLE III | SIMILAR-ITY III | MANU-FACTURING CONDITION iii |
| | | |

1022

CHARACTERISTIC y(t)

$y(t_0)\_N$

$y(t_B)\_N$

1023

SIMILARITY 1.0

SIMILARITY 0.0

TIME t

$t_0$    $t_B$    $t_T$

# FIG.11

**DISPLAY SCREEN** — 1110

| CONSUM-ABLE I | SIMILAR-ITY I | MANUFACTURING CONDITION i |
|---|---|---|
| CONSUM-ABLE II | SIMILAR-ITY II | MANUFACTURING CONDITION ii |
| CONSUM-ABLE III | SIMILAR-ITY III | MANUFACTURING CONDITION iii |

1121

1122

CHARACTERISTIC $y(t)$

$y(t_0)\_N$

$y(t_B)\_N$

1023

SIMILARITY 1.0

SIMILARITY 0.0

TIME $t$

$t_0$    $t_B$    $t_T$

EP 4 404 113 B1

# FIG.12

START OF
TRAINING PROCESS

↓

ACQUIRE CHARACTERISTIC DATA MEASURED
FOR EACH CONSUMABLE  ~S1201

↓

ACQUIRE FEATURE USED FOR
GENERATING CHARACTERISTIC DATA FROM
MEASUREMENT START TIME TO REFERENCE TIME  ~S1202

↓

CALCULATE ATTENUATION FACTOR FOR
CHARACTERISTIC DATA AFTER REFERENCE TIME  ~S1203

↓

GENERATE TRAINING DATA  ~S1204

↓

PERFORM TRAINING PROCESS ON
GAUSSIAN PROCESS REGRESSION MODEL  ~S1205

↓

NOTIFY MODEL PARAMETER  ~S1206

↓

END OF
TRAINING PROCESS

# FIG.13

```
        ┌─────────────────────────────┐
        │    START OF PREDICTION DATA  │
        │       DISPLAY PROCESS        │
        └─────────────────────────────┘
                      │
                      ▼
```

ACQUIRE CHARACTERISTIC DATA FROM MEASUREMENT START TIME TO REFERENCE TIME FOR CONSUMABLE TO BE PREDICTED ~S1301

ACQUIRE FEATURE USED FOR GENERATING CHARACTERISTIC DATA FROM MEASUREMENT START TIME TO REFERENCE TIME FOR CONSUMABLE TO BE PREDICTED ~S1302

GENERATE PREDICTIVE DATA ~S1303

CALCULATE SIMILARITY BETWEEN FEATURE OF EACH CONSUMABLE STORED AS TRAINING DATA AND FEATURE OF CONSUMABLE TO BE PREDICTED ~S1304

CONVERT SCALE OF CHARACTERISTIC DATA AFTER REFERENCE TIME FOR EACH CONSUMABLE ~S1305

DETERMINE DISPLAY APPEARANCE OF SCALE-CONVERTED CHARACTERISTIC DATA AFTER REFERENCE TIME FOR EACH CONSUMABLE BASED ON CORRESPONDING SIMILARITY ~S1306

INPUT FEATURE FROM MEASUREMENT START TIME TO REFERENCE TIME FOR CONSUMABLE TO BE PREDICTED TO GAUSSIAN PROCESS REGRESSION MODEL ~S1307

ACQUIRE PREDICTED ATTENUATION FACTOR AND 95% CONFIDENCE INTERVAL ~S1308

ACQUIRE PREDICTION DATA AND 95% CONFIDENCE INTERVAL (CONVERTED INTO CHARACTERISTIC DATA) ~S1309

GENERATE COMBINED GRAPH ~S1310

GENERATE TEXT TABLE ~S1311

GENERATE DISPLAY SCREEN AND DISPLAY THE SAME ~S1312

```
        ┌─────────────────────────────┐
        │    END OF PREDICTION DATA    │
        │       DISPLAY PROCESS        │
        └─────────────────────────────┘
```

# FIG.14

1010_3
1010_2
1010_1

**CHARACTERISTIC DATA AFTER REFERENCE TIME I**

CHARACTERISTIC $y(t)$

$y(t_B)\_N$

TIME $t$

$t_0$   $t_B$   $t_T$

920

**PREDICTION DATA N + 95% CONFIDENCE INTERVAL**

CHARACTERISTIC $y(t)$

$y(t_B)\_N$

TIME $t$

$t_0$   $t_B$   $t_T$

ID REFERENCE DATA   SIMILARITY

MAX. WIDTH AND MIN. WIDTH OF CONFIDENCE INTERVAL WHEN TRAINING PROCESS IS PERFORMED (CONVERTED INTO CHARACTERISTIC DATA)

1410

**DISPLAY SCREEN GENERATING PART**

1411

| LEVEL CALCULATION PART |

1001    1002

| TEXT DATA GENERATING PART | | GRAPH COMBINING PART |

DISPLAY DATA

1420

**DISPLAY SCREEN**

1021

| CONSUMABLE I | SIMILARITY I | MANUFACTURING CONDITION i |
| CONSUMABLE II | SIMILARITY II | MANUFACTURING CONDITION ii |
| CONSUMABLE III | SIMILARITY III | MANUFACTURING CONDITION iii |

1421

| BEST VALUE | 0.016 |
| WORST VALUE | 0.298 |
| PREDICTION VALUE | 0.083 |
| LEVEL | 24 |

CHARACTERISTIC $y(t)$

1022

$y(t_0)\_N$

$y(t_B)\_N$

1023

SIMILARITY 1.0

SIMILARITY 0.0

TIME $t$

$t_0$   $t_B$   $t_T$

# FIG.15

```
        ┌─────────────────────────────────┐
        │     START OF PREDICTION DATA     │
        │        DISPLAY PROCESS           │
        └─────────────────────────────────┘
                        │
                        ▼
  ┌──────────────────────────────────────────────────────┐
  │ ACQUIRE CHARACTERISTIC DATA FROM MEASUREMENT START TIME│──S1301
  │   TO REFERENCE TIME FOR CONSUMABLE TO BE PREDICTED    │
  └──────────────────────────────────────────────────────┘
                        │
                        ▼
  ┌──────────────────────────────────────────────────────┐
  │ ACQUIRE FEATURE USED FOR GENERATING CHARACTERISTIC DATA FROM│──S1302
  │MEASUREMENT START TIME TO REFERENCE TIME FOR CONSUMABLE TO BE PREDICTED│
  └──────────────────────────────────────────────────────┘
                        │
                        ▼
  ┌──────────────────────────────────────────────────────┐
  │            GENERATE PREDICTIVE DATA                    │──S1303
  └──────────────────────────────────────────────────────┘
                        │
                        ▼
  ┌──────────────────────────────────────────────────────┐
  │ CALCULATE SIMILARITY BETWEEN FEATURE OF EACH CONSUMABLE STORED│──S1304
  │  AS TRAINING DATA AND FEATURE OF CONSUMABLE TO BE PREDICTED│
  └──────────────────────────────────────────────────────┘
                        │
                        ▼
  ┌──────────────────────────────────────────────────────┐
  │      CONVERT SCALE OF CHARACTERISTIC DATA AFTER        │──S1305
  │       REFERENCE TIME FOR EACH CONSUMABLE              │
  └──────────────────────────────────────────────────────┘
                        │
                        ▼
  ┌──────────────────────────────────────────────────────┐
  │   DETERMINE DISPLAY APPEARANCE OF SCALE-CONVERTED      │──S1306
  │  CHARACTERISTIC DATA AFTER REFERENCE TIME FOR EACH     │
  │    CONSUMABLE BASED ON CORRESPONDING SIMILARITY        │
  └──────────────────────────────────────────────────────┘
                        │
                        ▼
  ┌──────────────────────────────────────────────────────┐
  │          ACQUIRE BEST VALUE AND WORST VALUE            │──S1501
  └──────────────────────────────────────────────────────┘
                        │
                        ▼
  ┌──────────────────────────────────────────────────────┐
  │ INPUT FEATURE FROM MEASUREMENT START TIME TO REFERENCE TIME FOR│──S1307
  │CONSUMABLE TO BE PREDICTED TO GAUSSIAN PROCESS REGRESSION MODEL│
  └──────────────────────────────────────────────────────┘
                        │
                        ▼
  ┌──────────────────────────────────────────────────────┐
  │       ACQUIRE PREDICTED ATTENUATION FACTOR            │──S1308
  │         AND 95% CONFIDENCE INTERVAL                   │
  └──────────────────────────────────────────────────────┘
                        │
                        ▼
  ┌──────────────────────────────────────────────────────┐
  │  ACQUIRE PREDICTION DATA AND 95% CONFIDENCE INTERVAL   │──S1309
  │        (CONVERTED INTO CHARACTERISTIC DATA)           │
  └──────────────────────────────────────────────────────┘
                        │
                        ▼
  ┌──────────────────────────────────────────────────────┐
  │            GENERATE COMBINED GRAPH                     │──S1310
  └──────────────────────────────────────────────────────┘
                        │
                        ▼
  ┌──────────────────────────────────────────────────────┐
  │               CALCULATE LEVEL                         │──S1502
  └──────────────────────────────────────────────────────┘
                        │
                        ▼
  ┌──────────────────────────────────────────────────────┐
  │       GENERATE TEXT TABLE AND DATA TABLE              │──S1503
  └──────────────────────────────────────────────────────┘
                        │
                        ▼
  ┌──────────────────────────────────────────────────────┐
  │    GENERATE DISPLAY SCREEN AND DISPLAY THE SAME       │──S1504
  └──────────────────────────────────────────────────────┘
                        │
                        ▼
        ┌─────────────────────────────────┐
        │      END OF PREDICTION DATA      │
        │         DISPLAY PROCESS          │
        └─────────────────────────────────┘
```

# FIG.16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3770620 A1
- JP 2010539473 W
- JP 2013217897 A
- JP 2019113524 A
- JP 2021150217 A

**Non-patent literature cited in the description**

- **TAYLOR SEAN J et al.** Forecasting at scale. *PeerJPreprints*, 27 July 2017